# EUROPEAN PATENT SPECIFICATION

(11) **EP 1 840 873 B1**
(45) Date of publication and mention of the grant of the patent: **02.12.2009**
(21) Application number: 07006188.2
(22) Date of filing: 26.03.2007
(51) Int. Cl.: G10L 19/00

(54) **Audio signal encoding method, program of audio signal encoding method, recording medium having program of audio signal encoding method recorded thereon, and audio signal encoding device**
Audiosignalkodierverfahren, Programm des Audiosignalkodierverfahrens, Aufzeichnungsmedium, auf dem das Programm des Audiosignalkodierverfahrens aufgezeichnet ist, und Audiosignalkodiervorrichtung
Procédé de codage de signaux audio, programme pour le procédé de codage de signaux audio, support d'enregistrement avec le programme pour le procédé de codage de signaux audio enregistré dessus et dispositif de codage de signaux audio

(30) Priority: 28.03.2006 JP 2006086927
(43) Date of publication of application: 03.10.2007
(73) Proprietor: Sony Corporation, Minato-ku Tokyo (JP)
(72) Inventor: Mogi, Yukihiko, Tokyo (JP); Shiota, Susumu, Tokyo (JP)
(74) Representative: Müller - Hoffmann & Partner

(56) References cited:
- EP-A1- 0 661 821
- EP-A2- 0 665 547
- EP-A2- 0 855 805
- WO-A-02/091363
- US-A1- 2004 030 548
- ASHIDA S ET AL: "Sampled-data audio signal compression with huffman coding" SICE 2004 ANNUAL CONFERENCE SAPPORO, JAPAN AUG. 4-6, 2004, PISCATAWAY, NJ, USA,IEEE, 4 August 2004 (2004-08-04), pages 972-976, XP010824665 ISBN: 4-907764-22-7

## Description

### BACKGROUND OF THE INVENTION

### 1. Field of the Invention

The present invention is for example applicable to cases where audio signals are encoded by Layer 1 and Layer 2 of MPEG (Moving Picture Experts Group) 1 and MPEG2. The present invention reduces the load of processing as compared with a example in the past when an audio signal is encoded on the basis of psychoacoustic analysis, by sorting evaluation criteria for bit allocation in advance, detecting a subband signal to which to allocate bits, and when sorting a recalculated evaluation criterion, partly changing the sequence of a latest sort result, thereby sorting the evaluation criterion.

### 2. Description of the Related Art

In the past, perceptual coding is known as an audio signal encoding process. Perceptual coding is referred to also as psychoacoustic coding. Perceptual coding encodes an audio signal while not allocating bits to a component difficult to perceive on the basis of a minimum audible limit and a masking effect, and thus efficiently encodes the audio signal using characteristics of a human auditory sense. Layer 1 and Layer 2 of MPEG1 and MPEG2 are widely known as an encoding method using the technology of perceptual coding.

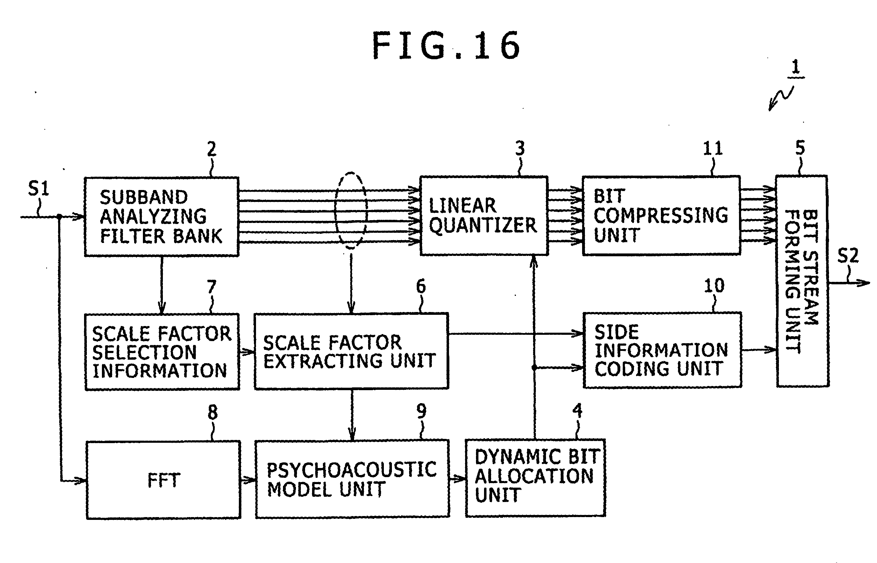

FIG. 16 is a block diagram showing an encoder for encoding an audio signal S1. This encoder 1 is formed by a digital signal processor, for example. The encoder 1 encodes the audio signal S1 by Layer 1 or Layer 2 of MPEG1 or Layer 1 or Layer 2 of MPEG2, and then outputs a bit stream S2. The audio signal S1 is an audio signal of a plurality of channels, and is for example linearly quantized 16-bit PCM (Pulse Code Modulation) data or linearly quantized 24-bit PCM data.

A subband analyzing filter bank 2 in the encoder 1 is formed by a polyphase filter bank, for example. The subband analyzing filter bank 2 divides the overall frequency band of the audio signal S1 into 32 frequency bands (subbands), subsamples signals in the respective bands, and then outputs subband signals. Incidentally, in Layer 1, 384 samples of the audio signal S1 are set and processed in one frame, whereas in Layer 2, 1152 samples of the audio signal S1 are set and processed in one frame.

A linear quantizer 3 quantizes the subband signals output from the subband analyzing filter bank 2 under control of a dynamic bit allocation unit 4, and then outputs the quantized subband signals. A bit compressing unit 11 bit-compresses the output data of the linear quantizer 3, and then outputs the bit-compressed data. A bit stream forming unit 5 adds output data of a side information coding unit 10, CRC (Cyclic Redundancy Check) code, and the like to the output data of the bit compressing unit 11, and then outputs a bit stream S2.

A scale factor extracting unit 6 detects a scale factor for each subband signal output from the subband analyzing filter bank 2. The scale factor is a coefficient indicating a maximum value of amplitude of each subband signal. In Layer 1, the scale factor extracting unit 6 sets 12 samples of each subband signal as one block, and detects a maximum value from absolute values of respective sample values of the subband signal for each block. In addition, the scale factor extracting unit 6 selects scale factors indicating amplitude values higher than the detected maximum value, and selects a scale factor indicating a minimum amplitude value from the selected scale factors.

In Layer 2, on the other hand, as in Layer 1, 12 samples are set as one block, and a scale factor is detected for each block. In addition, differences between the detected scale factors of successive blocks are detected, a successive pattern of the differences is represented by a transmission pattern of one to three bits, and the transmission pattern is output together with scale factor selection information 7. In Layer 2, the scale factor selection information 7 and the transmission pattern of one to three bits are transmitted as the scale factor of each block.

A fast Fourier transform (FFT) unit 8 subjects the audio signal S1 in units of 512 samples in Layer 1 and in units of 1024 samples in Layer 2 to a fast Fourier transform process.

A psychoacoustic model unit 9 calculates an SMR (Signal to Mask Ratio) for each subband from a result of the process of the fast Fourier transform unit 8 and the scale factor detected by the scale factor extracting unit 6, using a predetermined psychoacoustic model. The SMR is an evaluation value of each subband signal obtained from each subband signal to derive an evaluation criterion used for bit allocation to each subband signal. The SMR is a ratio (signal to mask ratio) between the maximum amplitude level of a subband signal and a maximum amplitude level masked by auditory or perceptual characteristics of a human (masking threshold value).

The dynamic bit allocation unit 4 calculates an amount of bits allocatable for transmission of the audio signal S1 itself, and calculates an amount of bits to be allocated to each subband from the calculated amount of bits on the basis of the SMR. In addition, the dynamic bit allocation unit 4 calculates the quantization scale of each subband signal. The dynamic bit allocation unit 4 controls the linear quantizer 3 to encode each subband signal with the calculated amount of bits to be allocated and the calculated quantization scale. Incidentally, the amount of bits allocatable for the transmission of the audio signal S1 itself is obtained by subtracting a header, CRC code, ancillary data, and bit allocation data from a total number of useable bits.

The side information coding unit 10 receives the amount of bits allocated to each subband signal, quantization scale data, scale factor data and the like as input data necessary for decoding, encodes the input data, and then outputs the result to the bit stream forming unit 5.

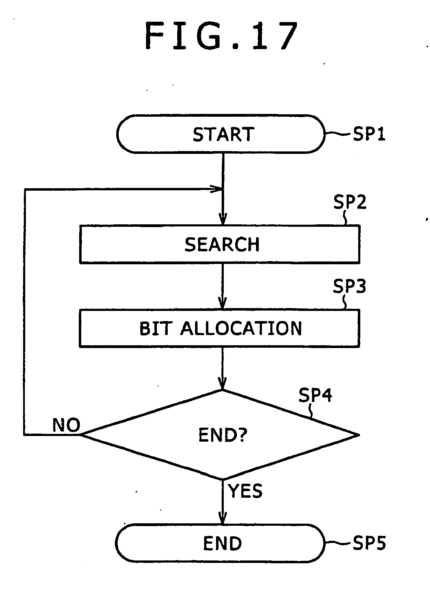

FIG. 17 is a flowchart representing in brief the process of the dynamic bit allocation unit 4. The dynamic bit allocation unit 4 performs this processing procedure for each block of the audio signal S1.

Specifically, starting this processing procedure, the dynamic bit allocation unit 4 calculates an MNR (Mask to Noise Ratio) of each subband signal from the SMR calculated in the psychoacoustic model unit 9. The MNR is an evaluation criterion for allocating bits to each subband signal. The MNR is obtained by subtracting the SMR [dB] from an SNR (Signal to Noise Ratio) [dB]. Incidentally, the SNR is the SNR of each subband signal when quantization is performed with n bits, for example. Since no bits are allocated to each subband signal immediately after the process of FIG. 17 is started, an initial value is applied to n.

Next, the dynamic bit allocation unit 4 proceeds from step SP1 to step SP2, where the dynamic bit allocation unit 4 searches the MNR of each subband signal to detect an MNR having a lowest value. In next step SP3, the dynamic bit allocation unit 4 calculates an amount of bits to be allocated to a subband signal having the detected MNR, and allocates the calculated amount of bits to the subband signal. In next step SP4, the dynamic bit allocation unit 4 determines whether allocation of all allocatable bits is completed. When a negative result is obtained in step SP4, the dynamic bit allocation unit 4 recalculates the MNR of the subband signal to which the bits are allocated in step SP3. The dynamic bit allocation unit 4 then returns to step SP2. When a positive result is obtained in step SP4, on the other hand, the dynamic bit allocation unit 4 proceeds from step SP4 to step SP5 to end the processing procedure.

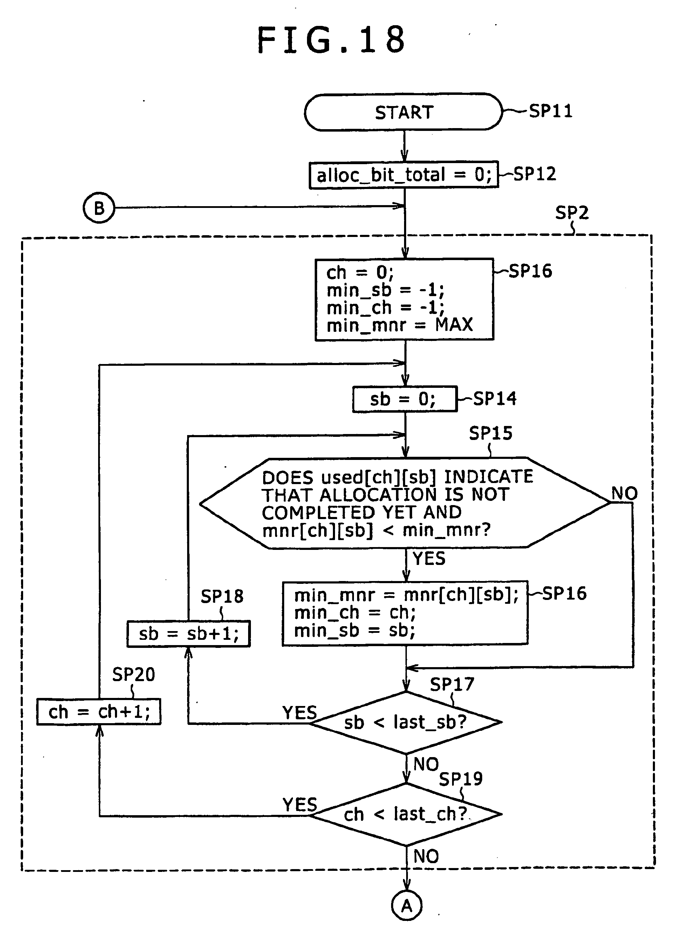

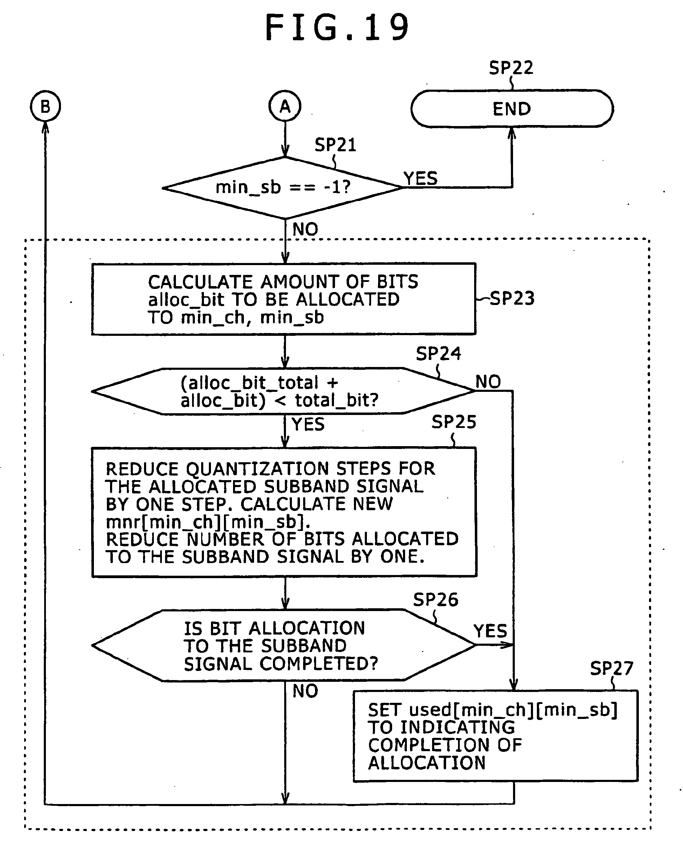

FIG. 18 and FIG. 19 are flowcharts representing in detail the processing procedure of FIG. 17. Incidentally, although the process of step SP4 is performed after step SP3 in FIG. 17, FIG. 17 describes the processing procedure for convenience in order to facilitate understanding. In practice, as shown in FIG. 18 and FIG. 19, the processes corresponding to step SP3 and step SP4 are provided in order opposite to that of the example of FIG. 17.

Specifically, starting this processing procedure, the dynamic bit allocation unit 4 calculates an MNR for each subband signal. The dynamic bit allocation unit 4 proceeds from step SP11 to step SP12, where the dynamic bit allocation unit 4 initializes a total number of bits allocation of which has been completed (alloc bit total) to a value 0.

Next, the dynamic bit allocation unit 4 proceeds to step SP13, where the dynamic bit allocation unit 4 initializes various variables. Incidentally, ch is a variable for identifying a channel of the audio signal S1. min ch and min sb are variables for identifying a channel and a subband signal, respectively, of an MNR having a minimum value. min mnr is the minimum value of the MNR. The dynamic bit allocation unit 4 initializes ch to a value 0, min ch and min sb to a value -1, and min mnr to a maximum value MAX of possible values.

Next, the dynamic bit allocation unit 4 in step SP14 initializes a variable sb for identifying a subband signal to a value 0. In next step SP15, the dynamic bit allocation unit 4 determines whether bit allocation to a subband signal (used[ch][sb]) identified by the variable sb for the channel identified by the variable ch is not completed yet and whether the value of the MNR of the subband signal is lower than the value of the variable min mnr.

Incidentally, a case where it is determined that bit allocation to the subband signal (used[ch][sb]) identified by the variable sb for the channel identified by the variable ch is not completed yet is a case where the total number of bits allocation of which has been completed (alloc bit total) exceeds a total number of allocatable bits (total bit), or a case where the number of bits allocated to the subband signal exceeds the number of bits allocatable to one subband signal. Incidentally, in a case of joint stereo, when bit allocation to the subband signal of the corresponding channel is completed, it is determined that bit allocation to the corresponding subband signal is completed.

When a positive result is obtained in step SP15, the dynamic bit allocation unit 4 proceeds from step SP15 to step SP16. In step SP16, the dynamic bit allocation unit 4 updates the minimum MNR value min mnr to the MNR of the channel and the subband signal identified by the variables ch and sb. In addition, the dynamic bit allocation unit 4 updates the variable min ch for identifying the channel having the minimum MNR value by the variable ch. Further, the dynamic bit allocation unit 4 updates the variable min sb for identifying the subband signal having the minimum MNR value by the variable sb. The dynamic bit allocation unit 4 then proceeds to step SP17.

When a negative result is obtained in step SP15, on the other hand, the dynamic bit allocation unit 4 directly proceeds from step SP15 to step SP17. In step SP17, the dynamic bit allocation unit 4 determines whether the value of the variable sb is lower than the value of a total number of subbands (last sb). When a positive result is obtained in step SP17, the dynamic bit allocation unit 4 proceeds to step SP18, where the dynamic bit allocation unit 4 increments the variable sb by a value of one to change the subband signal as processing object to a following subband signal. The dynamic bit allocation unit 4 then returns to step SP15. When a negative result is obtained in step SP17, on the other hand, the dynamic bit allocation unit 4 proceeds from step SP17 to step SP19. In step SP19, the dynamic bit allocation unit 4 determines whether the value of the variable ch is lower than the value of a total number of channels (last ch). When a positive result is obtained in step SP19, the dynamic bit allocation unit 4 proceeds to step SP20, where the dynamic bit allocation unit 4 increments the variable ch by a value of one to change the channel as processing object to a following channel. The dynamic bit allocation unit 4 then returns to step SP14.

By the process of steps SP13 to SP20, the dynamic bit allocation unit 4 sequentially changes the channel and the subband signal, and detects a minimum MNR value, thus performing the process of step SP2 described above with reference to FIG. 17. When the process of steps SP13 to SP20 is performed for all of the channels and the subband signals, a positive result is obtained in step SP19. The dynamic bit allocation unit 4 proceeds from step SP19 to step SP21 (FIG. 19).

In step SP21, the dynamic bit allocation unit 4 determines whether the variable min sb for identifying the subband signal having the minimum MNR value is maintained at the initial value (-1). When the variable min sb is maintained at the initial value (-1), a negative result is obtained in step SP15 for all the subband signals of all the channels. In this case, the dynamic bit allocation unit 4 proceeds from step SP21 to step SP22, where the dynamic bit allocation unit 4 ends the processing procedure. Incidentally, step SP21 and step SP22 correspond to step SP3 and step SP4 described above with reference to FIG. 17.

When a negative result is obtained in step SP21, on the other hand, the dynamic bit allocation unit 4 proceeds from step SP21 to step SP23. In this step SP23, the dynamic bit allocation unit 4 calculates the number of bits (alloc bit) to be allocated to the subband signal identified by the variable min sb for the channel identified by the variable min ch.

In next step SP24, the dynamic bit allocation unit 4 adds the number of bits (alloc bit) calculated in step SP23 to the total number of bits allocation of which has been completed so far (alloc bit total), and determines whether an addition value (alloc bit total + alloc bit) is lower than the total number of allocatable bits (total bit).

When a positive result is obtained in step SP24, the dynamic bit allocation unit 4 proceeds to step SP25, where the dynamic bit allocation unit 4 sets the addition value (alloc bit total + alloc bit) as the total number of bits allocation of which is completed (alloc bit total). In addition, the dynamic bit allocation unit 4 increases the number of bits assigned to the subband signal identified by the variable min sb for the channel identified by the variable min ch by the number of bits calculated in step SP23, and reduces quantization steps for the subband signal identified by the variable min sb for the channel identified by the variable min ch by one step. Further, the dynamic bit allocation unit 4 recalculates the MNR of this subband signal, and reduces the number of bits assigned to the subband signal by a value of one.

Next, the dynamic bit allocation unit 4 proceeds to step SP26, where the dynamic bit allocation unit 4 determines whether the number of bits already allocated to the subband signal exceeds the number of bits allocatable to one subband signal. When a negative result is obtained in step SP26, the dynamic bit allocation unit 4 returns from step SP26 to step SP13. When a positive result is obtained in step SP26, on the other hand, the dynamic bit allocation unit 4 proceeds from step SP26 to step SP27, where the dynamic bit allocation unit 4 sets the subband signal in a state of bit allocation being completed. The dynamic bit allocation unit 4 then returns to step SP13. Also when a negative result is obtained in step SP24, the dynamic bit allocation unit 4 proceeds from step SP24 to step SP27, where the dynamic bit allocation unit 4 sets the subband signal in a state of bit allocation being completed. The dynamic bit allocation unit 4 then returns to step SP13.

By the process of steps SP23 to SP27, the dynamic bit allocation unit 4 allocates bits to the subband signal having the minimum MNR value detected by the process of steps SP13 to SP20. Thus, steps SP23 to SP27 correspond to step SP4 in FIG. 17.

For such an encoding process, various devices are proposed in Japanese Patent Laid-Open No. Hei 8-123488 and the like.

When bits are allocated to each subband signal while the evaluation criterion is sequentially calculated, the MNRs of all the subband signals are searched to detect a minimum value again each time bits have been allocated to one subband signal. Therefore the encoding process in the past has a problem of a heavy processing load.

Document EP 0 855 805 A2 teaches a method of encoding digital audio signals wherein digital data are converted into a frequency spectrum. The frequency spectrum is divided into a plurality of frequency bands. A minimum limit of audibility characteristics among aural-psychological characteristics is changed in order to set a masking threshold. A process of finding a ratio of masking threshold to noise is performed for each frequency band, in particular based on power or energy of each frequency band. A number of quantized bits is allocated to each frequency band in accordance with the ratio of masking threshold to noise.

From document EP 0 661 821 A1 an encoding and decoding apparatus is known which is adapted for not causing deterioration of sound quality even when sine-wave signals are encoded. Inter alia, a bit allocation section is provided which comprises means for adopting a varied psychoacoustic characteristic according to the block length by receiving information representing the block length from a provided block length determining section or a bit allocating section comprising means for limiting a maximum amount of bits to be allocated to each of the frequency bands of a given digital input signal composed of musical sound.

Document EP 0 665 547 A2 discloses an encoding and decoding system which utilizes masking characteristics of channels for bit allocation in order to encode digitally sampled audio signals of at least two channels in units of an audio frame. The system comprises first and second divided band filter groups and a threshold value calculation means as well as bit allocation means and first and second quantization means and finally a multiplexing means. The provided bit allocator is adapted to preferably allocate the means to the respective divided bands of first and second channels using a predetermined number of bits per one audio frame. On the other hand the provided bit allocator may allocate the bits with respect to all the divided bands of a given second channel so as to have the MNR exceeding a second masking threshold value and in particular earlier than said of a first bit allocator, wherein a second bit allocator is adapted to output a bit allocation completion information to the given first bit allocator and said first bit allocator generates a bit ratio information based on the bit allocation completion information.

Document WO 02/091363 A1 teaches a process of audio coding, wherein a received signal is partitioned into a plurality of frequency bands. Amplitudes of the signal are compared in various frequency-divided bands with respect to certain threshold values. The signals of the divided frequency bands are coded on a priority basis such that frequency bands, in which the amplitude of the signal in the particular frequency band exceeds its respective threshold value by a greatest amount, are coded according to a given coding scheme. For other frequency bands a noise fill parameter is selectively allocated.

### SUMMARY OF THE INVENTION

The present invention has been made in view of the above, and it is desirable to provide an audio signal encoding method, a program of the audio signal encoding method, a recording medium having the program of the audio signal encoding method recorded thereon, and an audio signal encoding device that can reduce the load of processing as compared with an existing example when an audio signal is encoded on the basis of psychoacoustic analysis.

The objects underlying the present invention are achieved by an audio signal encoding method according to independent claim 1, by a program of an audio signal encoding method according to independent claim 4, by a recording medium on which a program of an audio signal encoding method is recorded according to independent claim 5, and by an audio signal encoding device according to independent claim 6. Preferred embodiments of the audio signal encoding method according to the present invention are within the scope of the respective dependent claims.

According to the configurations of the embodiments of the invention, evaluation criteria for bit allocation are sorted in advance and a subband signal to which to allocate bits is detected. When a recalculated evaluation criterion is to be sorted, the evaluation criterion can be sorted by partly changing the sequence of a latest sort result. It is therefore possible to detect a subband signal to which to allocate bits by a simpler process as compared with the existing example. Hence, when an audio signal is encoded on the basis of psychoacoustic analysis, the load of processing can be reduced as compared with the existing example.

According to the present invention, when an audio signal is encoded on the basis of psychoacoustic analysis, the load of processing can be reduced as compared with the existing example.

### BRIEF DESCRIPTION OF THE DRAWINGS

FIG. 1 is a flowchart of a processing procedure of a dynamic bit allocation unit 4 in an encoder according to a first embodiment of the present invention;
FIGS. 2A, 2B, and 2C are schematic diagrams of assistance in explaining the processing procedure of FIG. 1;
FIGS. 3A, 3B, and 3C are schematic diagrams showing a state continued from FIGS. 2A, 2B, and 2C;
FIGS. 4A, 4B, and 4C are schematic diagrams showing a state continued from FIGS. 3A, 3B, and 3C;
FIG. 5 is a flowchart representing details of step SP42 in the processing procedure of FIG. 1 together with related processes;
FIG. 6 is a flowchart representing in detail the processing procedure of steps SP43, SP44, and SP46 in FIG. 1;
FIGS. 7A, 7B, and 7C are schematic diagrams of assistance in explaining the processing procedure of FIG. 6;
FIG. 8 is a flowchart representing in detail the process of step SP45 in FIG. 1;
FIG. 9 is a flowchart of a processing procedure of a dynamic bit allocation unit 4 in an encoder according to a second embodiment of the present invention;
FIGS. 10A, 10B, and 10C are schematic diagrams of assistance in explaining the processing procedure of FIG. 9;
FIGS. 11A, 11B, and 11C are schematic diagrams showing a state continued from FIGS. 10A, 10B, and 10C;
FIG. 12 is a flowchart representing in detail the process of step SP100 in the processing procedure of FIG. 9;
FIG. 13 is a characteristic curve diagram of assistance in explaining occurrence of noise;
FIG. 14 is a characteristic curve diagram of assistance in explaining prevention of noise;
FIG. 15 is a flowchart of a processing procedure of a dynamic bit allocation unit 4 in an encoder according to a third embodiment of the present invention;
FIG. 16 is a block diagram showing an encoder;
FIG. 17 is a flowchart of a processing procedure of a dynamic bit allocation unit 4 in an encoder in the past;
FIG. 18 is a flowchart representing in detail the processing procedure of FIG. 17; and
FIG. 19 is a flowchart continued from FIG. 18.

### DETAILED DESCRIPTION OF THE PREFERRED EMBODIMENTS

Preferred embodiments of the present invention will hereinafter be described in detail, referring to the drawings as appropriate.

### [First Embodiment]

### (1) Configuration of Embodiment

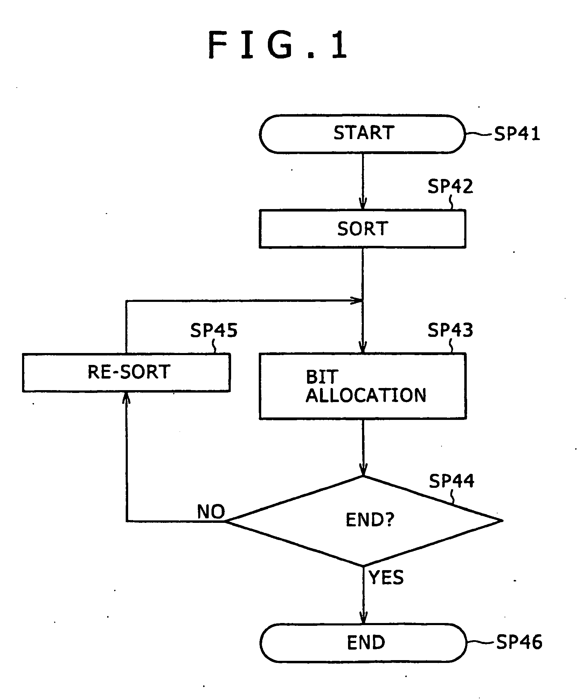

FIG. 1 is a flowchart of a processing procedure of a dynamic bit allocation unit 4 in an encoder according to a first embodiment of the present invention, for comparison with FIG. 17. The encoder according to the first embodiment is formed in the same manner as the encoder described above with reference to FIG. 16 except for the different processing procedure of the dynamic bit allocation unit 4 in the encoder according to the first embodiment. Therefore the following description will be made using the configuration of FIG. 16 as appropriate.

The dynamic bit allocation unit 4 performs the processing procedure for each block set in an audio signal S1, and thereby assigns bits to each subband signal. Starting this processing procedure, as described above with reference to FIG. 17, the dynamic bit allocation unit 4 calculates the MNR of each subband signal. The dynamic bit allocation unit 4 then proceeds from step SP41 to step SP42, where the dynamic bit allocation unit 4 sorts the calculated MNRs in increasing order.

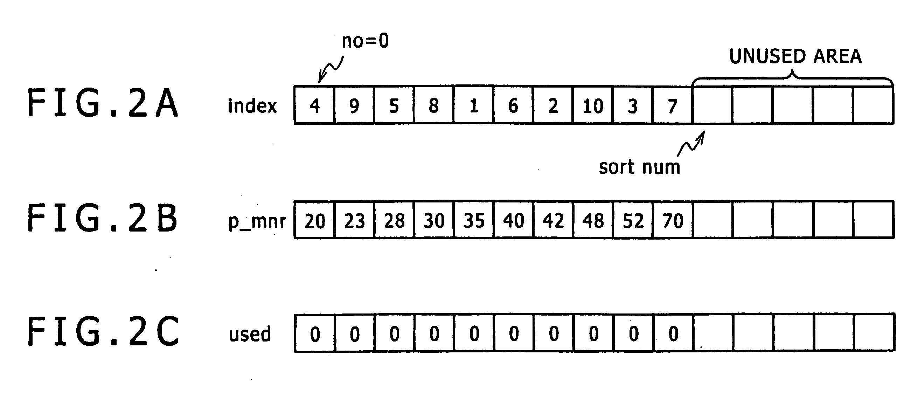

As shown in FIGS. 2A, 2B, and 2C, the dynamic bit allocation unit 4 secures a certain area in a not shown memory, sorts combinations each including an MNR (p mnr (FIG. 2B)), an index index (FIG. 2A) for identifying a channel and a subband signal for which the MNR is detected, and a status used (FIG. 2C) indicating a status of processing for the index index for all subband signals of all channels by MNR, and then stores the result in the memory. The value 0 of the status (used) indicates a state in which no bits are allocated; the value 1 of the status (used) indicates a state in which bits are being allocated; and the value 2 of the status (used) indicates a state in which bit allocation is completed. The certain area is set to have a sufficient free space to store the combinations each including an index index, a status used, and an MNR for all the subband signals of all the channels and repeat the process of step SP44 to be described later.

Thus, in the example of FIGS. 2A, 2B, and 2C, a combination of index = 4, p mnr = 20, and used = 0 is stored in a head area identified by a variable no = 0 in a memory space. A combination of an MNR recorded in the memory, an index index for identifying a channel and a subband signal for which the MNR is detected, and a status used indicating a status of processing for the index index will hereinafter be referred to as an MNR combination as appropriate. The variable no identifies the MNR combination.

Next, the dynamic bit allocation unit 4 proceeds to step SP43, where the dynamic bit allocation unit 4 detects an MNR having a lowest value recorded at the head of a sort result. In addition, on the basis of an index index for the detected MNR, the dynamic bit allocation unit 4 allocates bits to the subband signal of a corresponding channel, and then recalculates the MNR of the subband signal to which the bits are allocated.

Then the dynamic bit allocation unit 4 proceeds to step SP44, where the dynamic bit allocation unit 4 determines whether the allocation of all allocatable bits is completed. When a negative result is obtained in step SP44, the dynamic bit allocation unit 4 proceeds to step SP45. In this step SP45, the dynamic bit allocation unit 4 applies the MNR recalculated in step SP44 to re-sort the MNRs recorded in the memory.

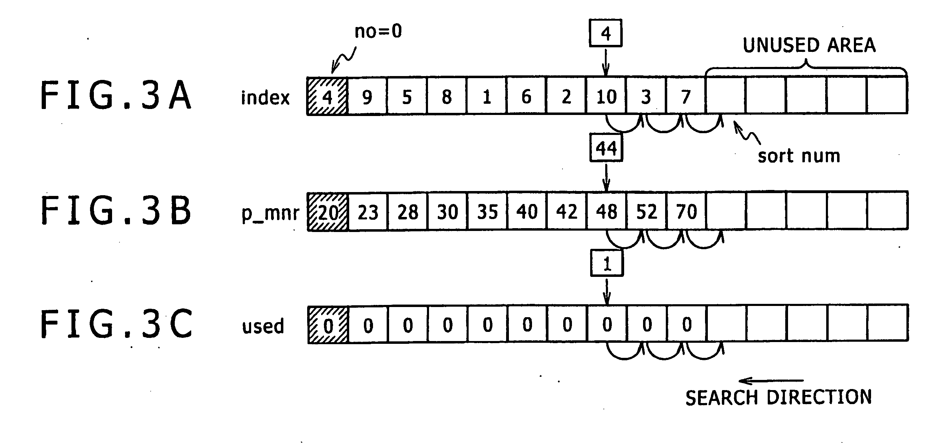

As shown in FIGS. 3A, 3B, and 3C, in the sorting process in step SP44, the dynamic bit allocation unit 4 sorts the MNRs by partially changing a sequence of a sort result so far. Specifically, the dynamic bit allocation unit 4 sequentially moves combinations of the sort result so far to an end side as indicated by arrows in the memory where the sort result is recorded until an MNR having a value lower than the recalculated MNR is detected. When an MNR having a value lower than the recalculated MNR is detected, the dynamic bit allocation unit 4 records a combination including the recalculated MNR in a free space obtained by moving the combinations. Thus, the example of FIGS. 3A, 3B, and 3C is a case where bits are allocated to the subband signal of index = 4 stored in the head area of the memory space, a value 44 is obtained by recalculating the MNR, records of combinations of no = 7 to 9 are moved to the end side one by one, and the recalculation result is recorded in a free space of no = 7 obtained by moving the combinations. As indicated by hatching, after recalculating and sorting the MNR, the dynamic bit allocation unit 4 excludes the record including the MNR before the recalculation from objects for subsequent processing.

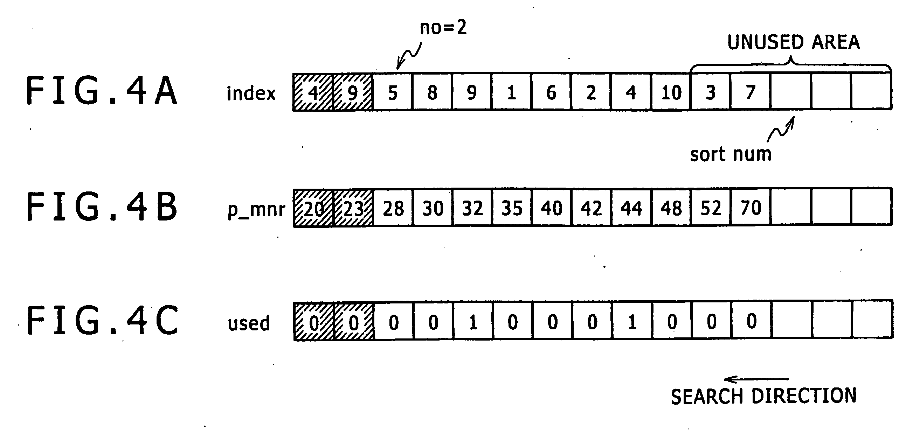

After completing the process of step SP45, the dynamic bit allocation unit 4 returns to step SP43, where the dynamic bit allocation unit 4 detects an MNR having a lowest value recorded at the head of the processing objects from the sort result obtained by the sorting in step SP45. Thus, in the example of FIGS. 3A, 3B, and 3C, an MNR of index = 9 identified by no = 1 is detected as MNR having a lowest value. Therefore, in this case, the dynamic bit allocation unit 4 allocates bits to the subband signal of index = 9 and recalculates the MNR in step SP43, and then further sorts the MNRs in step SP45 as shown in FIGS. 4A, 4B, and 4C. Incidentally, FIGS. 4A, 4B, and 4C illustrate a case where an MNR having a value 32 is obtained by recalculation for the subband signal of index = 9. Incidentally, as will be described later, when bit allocation to the subband signal to which the bits are allocated is completed as a result of allocating the bits in step SP43, the dynamic bit allocation unit 4 omits the process of step SP45 and repeats the process of step SP43.

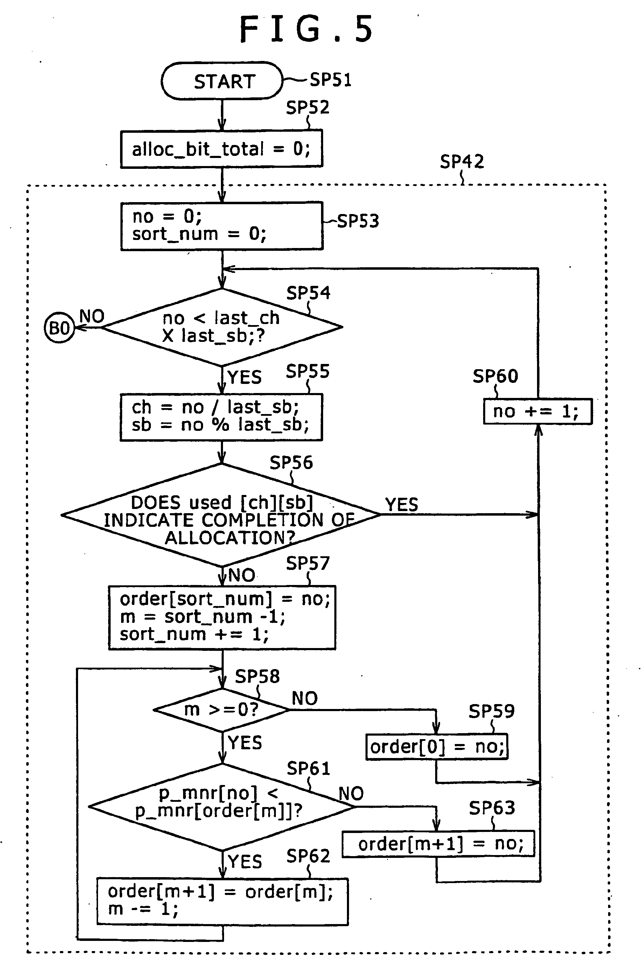

FIG. 5 is a flowchart representing details of step SP42 in the processing procedure of FIG. 1 together with related processes. Starting this processing procedure, the dynamic bit allocation unit 4 calculates an MNR for each subband signal when quantization is performed with one bit, for example. The dynamic bit allocation unit 4 then proceeds from step SP51 to step SP52.

In step SP52, the dynamic bit allocation unit 4 initializes a total number of bits (alloc bit total) indicating the number of bits allocation of which has been completed to a value 0. Incidentally, for representations consistent with the existing example, the index index will hereinafter be ch = index /last sb and sb = index % last sb. Hence, p mnr[index] indicates the same value as mnr[ch][sb]. Incidentally, % denotes modulo calculation for obtaining a remainder, and ch and sb are variables for identifying a channel and a subband signal.

Next, the dynamic bit allocation unit 4 proceeds to step SP53, where the dynamic bit allocation unit 4 initializes each of a variable no and a variable sort num to a value 0. Incidentally, the variable sort num indicates a number of objects to be sorted. The variable no in the process represented in FIG. 5 identifies a sort object.

Next, the dynamic bit allocation unit 4 proceeds to step SP54, where the dynamic bit allocation unit 4 determines whether the value of the variable no is lower than a multiplication value last ch X last sb obtained by multiplying together a total number last ch of channels and a total number last sb of subbands, and thereby determines whether the processing of all sort objects is not completed.

When a positive result is obtained in step SP54, the dynamic bit allocation unit 4 proceeds to step SP55. In step SP55, the dynamic bit allocation unit 4 converts the variable no into the variable ch and the variable sb for identifying a channel and a subband signal.

In next step SP56, the dynamic bit allocation unit 4 determines a status used [ch][sb] of a subband signal identified by the variable sb for a channel identified by the variable ch, and thereby determines whether allocation of bits to the subband signal is completed.

When a negative result is obtained in step SP56, the dynamic bit allocation unit 4 proceeds to step SP57. In step SP57, the dynamic bit allocation unit 4 stores an MNR combination identified by the variable no in an area sort num following an end of MNR combinations stored in the memory so far. Incidentally, order[x] = y denotes that the combination identified by no = y is stored in an xth area from the head side of the memory space and conversely the combination identified by no = y is loaded into the xth area from the head side of the memory space. In the present embodiment, the MNR combination stored in the memory in step SP57 is a sort object. In addition, the dynamic bit allocation unit 4 sets a variable m for identifying a comparison object for comparison with the sort object by recording order in the memory space to sort num - 1, thereby setting an MNR combination stored at a position immediately preceding the sort object as the comparison object. The dynamic bit allocation unit 4 also increments the variable sort num indicating the sort number by a value of one. By performing the process of step SP57, the dynamic bit allocation unit 4 prepares for a sort.

Next, the dynamic bit allocation unit 4 proceeds to step SP58, where the dynamic bit allocation unit 4 determines whether the variable m is larger than a value 0. When the sort object is an MNR combination recorded at the head of the memory space, no MNR combination preceding this combination is recorded, and thus there is no comparison object. In addition, there is no comparison object after the comparison object is sequentially changed from the end side to the head side and the first MNR combination becomes the comparison object. Hence, in these cases, the dynamic bit allocation unit 4 obtains a negative result in step SP58, and proceeds from step SP58 to step SP59.

In step SP59, the dynamic bit allocation unit 4 records the combination of the sort object at the head of the memory space (order[0] = no).

Next, the dynamic bit allocation unit 4 proceeds to step SP60, where the dynamic bit allocation unit 4 increments the variable no by a value of one, and then returns to step SP54.

When a positive result is obtained in step SP58, on the other hand, the dynamic bit allocation unit 4 proceeds to step SP61. In step SP61, the dynamic bit allocation unit 4 determines whether the MNR (p mnr[no]) of the combination identified by the variable no is lower than the MNR (p mnr[order[m]]) of the combination identified by the variable m, that is, whether the MNR of the sort object is lower than the MNR of the comparison object.

When a positive result is obtained in step SP61, the dynamic bit allocation unit 4 proceeds to step SP62, where the dynamic bit allocation unit 4 moves the record of the comparison object in the memory space to the end side by one (order[m + 1] = order[m]). In addition, the dynamic bit allocation unit 4 decrements the variable m by a value of one to change the comparison object to a combination recorded at an immediately preceding position. The dynamic bit allocation unit 4 then returns to step SP58.

When a negative result is obtained in step SP61, on the other hand, the dynamic bit allocation unit 4 proceeds from step SP61 to step SP63, where the dynamic bit allocation unit 4 records the combination of the sort object at a recording position before the comparison object is moved (order[m + 1] = no). The dynamic bit allocation unit 4 then proceeds to step SP60.

The dynamic bit allocation unit 4 sequentially stores MNR combinations in the memory space by performing the process of steps SP53 to SP63. At this time, each time one combination is to be stored in the memory, as described above with reference to FIGS. 3A, 3B, and 3C, already stored combinations are sequentially moved to the end side in the memory space until an MNR having a lower value than the MNR to be stored is detected, and the MNR combination is stored in a free space created as a result, whereby the sort process is performed.

When completing the sort process, the dynamic bit allocation unit 4 obtains a negative result in step SP54, and then proceeds to step SP43.

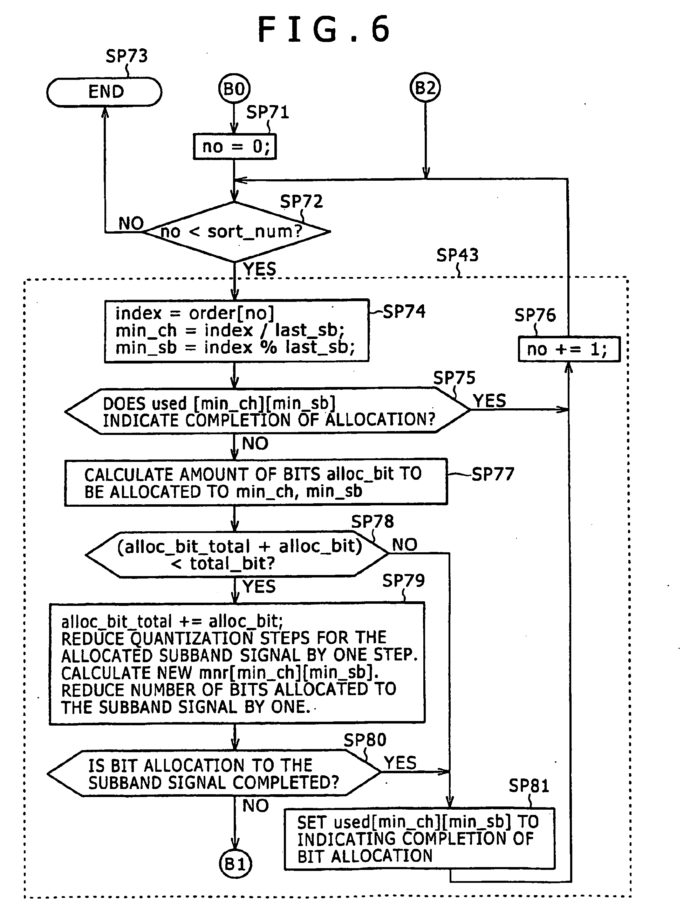

FIG. 6 is a flowchart representing in detail the processing procedure of steps SP43, SP44, and SP46 in FIG. 1. Incidentally, although the process of step SP44 is performed after step SP43 in FIG. 1, FIG. 1 describes the processing procedure for convenience in order to facilitate understanding. In practice, the processing procedure is performed in order shown in FIG. 6. Specifically, starting the processing procedure, the dynamic bit allocation unit 4 proceeds to step SP71, where the dynamic bit allocation unit 4 initializes the variable no to a value 0.

Next, the dynamic bit allocation unit 4 proceeds to step SP72, where the dynamic bit allocation unit 4 determines whether the value of the variable no is lower than the sort number sort num, and thereby determines whether the process is to be ended. When the variable no is equal to or larger than the sort number sort num, the dynamic bit allocation unit 4 proceeds from step SP72 to step SP73, where the dynamic bit allocation unit 4 ends the processing procedure. Hence, step SP72 and step SP73 correspond to step SP44 and step SP46 described above with reference to FIG. 1.

When the value of the variable no is lower than the sort number sort num, on the other hand, the dynamic bit allocation unit 4 proceeds from step SP72 to step SP74. In step SP74, the dynamic bit allocation unit 4 detects the index index of a combination identified by the variable no in the memory space (index = order[no]), and converts the index index into variables min ch and min sb identifying a channel and a subband signal (min ch = index / last sb and min sb = index % last sb). Hence, in this case, the channel and subband signal of an MNR having a lowest value sorted and recorded at the head area of the memory space is detected among processing objects.

Next, the dynamic bit allocation unit 4 proceeds to step SP75, where the dynamic bit allocation unit 4 determines a status used[min ch][min sb] set for the combination of the index index detected in step SP74, and thereby determines whether bit allocation to the subband signal of the index index is completed.

When a positive result is obtained in step SP75, the dynamic bit allocation unit 4 proceeds from step SP75 to step SP76, where the dynamic bit allocation unit 4 increments the variable no by a value of one. The dynamic bit allocation unit 4 then returns to step SP72. When a negative result is obtained in step SP75, on the other hand, the dynamic bit allocation unit 4 proceeds from step SP75 to step SP77.

Thus, the dynamic bit allocation unit 4 performs the process of steps SP71, SP72, SP74, and SP75 in this order, and when a positive result is obtained in step SP75, the dynamic bit allocation unit 4 further performs the process of steps SP76, SP72, SP74, and SP75 in this order. The dynamic bit allocation unit 4 thereby detects a combination to which bit allocation is not completed and which has a lowest MNR recorded at a foremost position among the combinations recorded as processing objects in the memory.

When detecting the combination having the lowest MNR, the dynamic bit allocation unit 4 proceeds from step SP75 to step SP77, where the dynamic bit allocation unit 4 calculates an amount of bits (alloc bit) to be allocated to the subband signal of the combination having the lowest MNR which subband signal is detected in step SP74. In next step SP78, the dynamic bit allocation unit 4 adds the calculated amount of bits (alloc bit) to the total number of bits (alloc bit total), and determines whether an addition value (alloc bit total + alloc bit) is lower than a total number of allocatable bits (total bit).

When a positive result is obtained in step SP78, the dynamic bit allocation unit 4 proceeds to step SP79, where the dynamic bit allocation unit 4 sets the addition value (alloc bit total + alloc bit) as the total number of bits (alloc bit total) allocation of which is completed. In addition, the dynamic bit allocation unit 4 sets the status used of the combination identified by the variable no to a value 1 indicating a state of bits being allocated. Further, the dynamic bit allocation unit 4 adds the number of bits calculated in step SP77 to the number of bits assigned to the subband signal of the combination identified by the variable no, and recalculates the MNR. Further, the dynamic bit allocation unit 4 reduces quantization steps for the subband signal identified by the variable min sb for the channel identified by the variable min ch by one step. Further, the dynamic bit allocation unit 4 reduces the number of bits assigned to the subband signal by a value of one.

Next, the dynamic bit allocation unit 4 in step SP80 determines whether the number of bits already allocated to the subband signal of the combination identified by the variable no exceeds the number of bits allocatable to one subband signal, and thereby determines whether allocation of bits to the subband signal is completed.

When a positive result is obtained in step SP80, the dynamic bit allocation unit 4 proceeds to step SP81, where the dynamic bit allocation unit 4 changes the status used of the combination whose status used has been set to the value 1 in step SP79 to a value 2 indicating that bit allocation is completed. The dynamic bit allocation unit 4 then returns to step SP76.

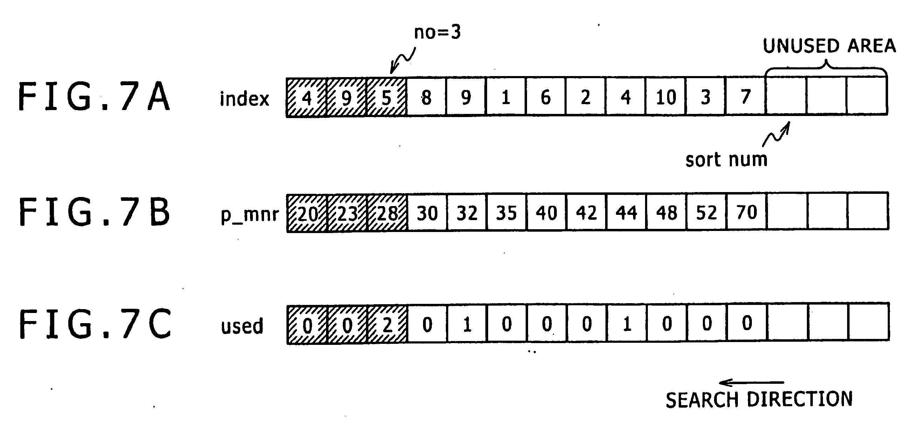

Thus, when bit allocation to the subband signal to which bits are allocated in step SP79 is completed, the dynamic bit allocation unit 4 proceeds from step SP81 to step SP76. As shown in FIGS. 7A, 7B, and 7C for comparison with FIGS. 4A, 4B, and 4C, in this case, bits are allocated to a subband signal having a next lowest MNR without the sort process being performed, whereby the number of sorts is reduced. Incidentally, FIGS. 7A, 7B, and 7C illustrate a case where the subband signal of the index index = 5 is detected as subband signal having a lowest MNR and bit allocation to the subband signal is completed. In this case, sorting of the subband signal of the index index = 5 is not performed, and bits are allocated to a next subband signal of the index index = 8.

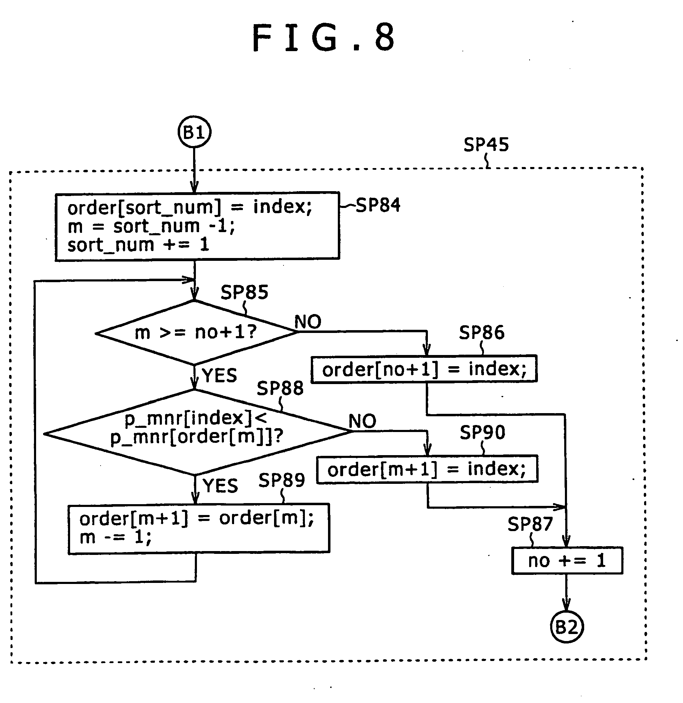

FIG. 8 is a flowchart representing in detail the process of step SP45 in FIG. 1. Starting this processing procedure, the dynamic bit allocation unit 4 proceeds to step SP84, where the dynamic bit allocation unit 4 stores the combination of the subband signal to which bits are allocated in previous step SP79 in an area sort num following an end of the MNR combinations stored in the memory (order[sort num] = index). In addition, the dynamic bit allocation unit 4 sets the combination stored at the position following the end as a sort object. Further, the dynamic bit allocation unit 4 sets the variable m for identifying a comparison object to sort num - 1, and thereby sets an MNR combination recorded at a position immediately preceding the sort object as the comparison object. Further, the dynamic bit allocation unit 4 increments the variable sort num by a value of one.

Next, the dynamic bit allocation unit 4 proceeds to step SP85, where the dynamic bit allocation unit 4 determines whether the variable m is higher than a value no + 1. No comparison object exists after the comparison object is sequentially changed from the end side to the head side and the MNR combination at the head of the processing objects becomes the comparison object. Hence, in these cases, the dynamic bit allocation unit 4 obtains a negative result in step SP85, and proceeds from step SP85 to step SP86.

In step SP86, the dynamic bit allocation unit 4 records the combination of the sort object at an (no + 1)th position of the memory space (order[no + 1] = index). Incidentally, the MNR of this combination is the MNR recalculated in step SP79. Incidentally, in step SP86, when the recording position (order[]) of the combination of the sort object is set and the variable sort num is set such that the subband signal for which a positive result is obtained in previous step SP80 and to which bit allocation is thus completed is not included as a comparison object in the subsequent sort process, a processing load can be further reduced.

Next, the dynamic bit allocation unit 4 proceeds to step SP87, where the dynamic bit allocation unit 4 increments the variable no by a value of one. The dynamic bit allocation unit 4 returns to step SP72 (FIG. 6).

When a positive result is obtained in step SP85, on the other hand, the dynamic bit allocation unit 4 proceeds to step SP88. In step SP88, the dynamic bit allocation unit 4 determines whether the MNR (p mnr[index]) of the sort object identified by the index index is lower than the MNR (p mnr[order[m]]) of the combination identified by the variable m.

When a positive result is obtained in step SP88, the dynamic bit allocation unit 4 proceeds to step SP89, where the dynamic bit allocation unit 4 moves the record of the comparison object in the memory space to the end side by one (order[m + 1] = order[m]). In addition, the dynamic bit allocation unit 4 decrements the variable m by a value of one to change the comparison object to a combination recorded at an immediately preceding position. The dynamic bit allocation unit 4 then returns to step SP85.

When a negative result is obtained in step SP88, on the other hand, the dynamic bit allocation unit 4 proceeds from step SP88 to step SP90, where the dynamic bit allocation unit 4 records the combination of the sort object at a recording position immediately succeeding the comparison object (order[m + 1] = index). The dynamic bit allocation unit 4 then proceeds to step SP87.

### (2) Operation of Embodiment

With the above configuration, in the encoder according to the present embodiment (see FIG. 16), a subband analyzing filter bank 2 divides a sequentially input audio signal S1 into a plurality of subband signals, and a linear quantizer 3 quantizes each subband signal. A bit compressing unit 11 bit-compresses a result of the quantization process, and then a bit stream forming unit 5 converts the bit-compressed result into a bit stream S2 and outputs the bit stream S2. A fast Fourier transform unit 8 subjects the audio signal S1 to a fast Fourier transform process. A psychoacoustic model unit 9 analyzes a result of the fast Fourier transform process, and detects the SMR (signal-to-mask ratio) of each subband signal. The dynamic bit allocation unit 4 determines the MNR (Mask to Noise Ratio) of each subband signal of the audio signal S1 from the signal-to-mask ratio SMR, and determines bit allocation and a quantization scale on the basis of the MNR. The linear quantizer 3 performs the quantization process with the bit allocation and the quantization scale.

The bit allocation process in the dynamic bit allocation unit 4 is performed by repeating a process of detecting a subband signal with an MNR having a lowest value among the plurality of subband signals to which to allocate bits and a process of allocating bits to the detected subband signal and recalculating the MNR, and allocating all allocatable bits to each subband signal of each channel. In addition, the quantization scale of each subband signal is set so as to correspond to this bit allocation.

In the present embodiment, the dynamic bit allocation unit 4 (FIG. 1) first sorts the MNRs of respective subbands in increasing order of MNR, and allocates bits to the subband signal having the MNR recorded at the head of a result of the sort (FIGS. 2A, 2B, and 2C). The MNR of the subband signal to which the bits are allocated is recalculated and re-sorted (FIGS. 3A, 3B, and 3C). Bits are allocated to the subband signal having the MNR recorded at the head of the re-sorted MNRs. The dynamic bit allocation unit 4 repeats a process of recalculating and re-sorting the MNR and a process of allocating bits to the subband signal having the MNR recorded at the head of the re-sorted MNRs, whereby all bits are allocated to each subband signal of each channel.

Thus, the dynamic bit allocation unit 4 performs a sort in advance, and then detects a subband signal to which to allocate bits. Therefore, as compared with the existing example, the subband signal to which to allocate bits can be detected more quickly.

Specifically, the MNRs of the audio signal S1 are first calculated on the basis of an initial setting, and combinations of the calculated MNRs, indexes index, and statuses used are stored in the memory one by one and sorted (FIG. 5).

At this time, an MNR combination is stored at an end of a row of MNR combinations already stored in the memory (step SP57 (FIG. 5)), and the order of arrangement is changed between the MNR combination and a combination stored at an immediately preceding position until an MNR having a lower value is detected (steps SP58, SP61, SP62, SP58, ..., SP58, SP61, and SP63 in this order, or steps SP58, SP61, SP62, SP58, ..., SP58, and SP59 in this order (FIG. 5)), whereby a sort is performed.

As a result of the sort, an MNR combination stored at the head includes an MNR having a lowest value, and bits are allocated to the channel and the subband signal of the combination at the head (steps SP71 and SP74, SP75, and SP77 in this order (FIG. 6)).

In addition, for a recalculated MNR, a corresponding MNR already stored in the memory is excluded from processing objects, and the recalculated MNR is stored at an end of a row of MNR combinations already stored in the memory (step SP84 (FIG. 8)). Until an MNR having a lower value is detected, the order of arrangement is changed between the MNR combination and a combination stored at an immediately preceding position, and thereby a sort is performed (steps SP85, SP88, SP89, SP88, ..., SP85, SP88, and SP87 in this order, or steps SP85, SP88, SP89, SP88, ..., SP85, and SP90 in this order (FIG. 8)).

As a result of sorting the recalculated MNR, an MNR combination stored at the head includes an MNR having a lowest value, and bits are allocated to the channel and the subband signal of the combination at the head (steps SP71 and SP74, SP75, and SP77 in this order (FIG. 6)).

Thus, when bit allocation to the subband signal of the combination at the head of the sort result is completed, it suffices to allocate bits to the subband signal of a next combination in the sort result (steps SP56, SP60, SP54, SP55, SP56, and SP57 in this order (FIG. 5)). It is therefore possible to reduce the number of sorts as the processing progresses, and simplify the process of detecting a minimum MNR for subband signals to which bits can be allocated.

Although MNRs are sorted in advance and a minimum MNR is detected quickly, the MNRs are sorted in the present embodiment, and it thus appears that a load of the processing viewed as a whole is not different from that of the existing example. In the present embodiment, however, when a recalculated MNR is to be sorted, the combination of the recalculated MNR is stored at an end of a sort result already stored in the memory, and thereafter the order of arrangement is changed between the combination of the recalculated MNR and a combination stored at an immediately preceding position until an MNR having a lower value is detected, whereby a sort is performed. Thus, the sort result so far is utilized effectively, and the MNRs are sorted by partly changing the sequence of the sort result so far. Hence, the load of the processing viewed as a whole can be reduced as compared with the existing example. In actuality, when the sort process and bit allocation are performed as in the present embodiment, an amount of processing of the encoder as a whole can be reduced by 52 [%] as compared with the processing performed by the existing example.

### (3) Effect of Embodiment

According to the above configuration, MNRs are sorted in advance and a subband signal to which to allocate bits is detected. When a recalculated MNR is to be sorted, the combination of the recalculated MNR is stored at an end of a row of MNR combinations already stored in the memory, and thereafter the order of arrangement is changed between the combination of the recalculated MNR and a combination stored at an immediately preceding position until an MNR having a lower value is detected, whereby a sort is performed. It is thus possible to utilize the sort result so far effectively, and sort the MNRs by partly changing the sequence of the sort result so far. Hence, the load of processing can be reduced as compared with the existing example.

### [Second Embodiment]

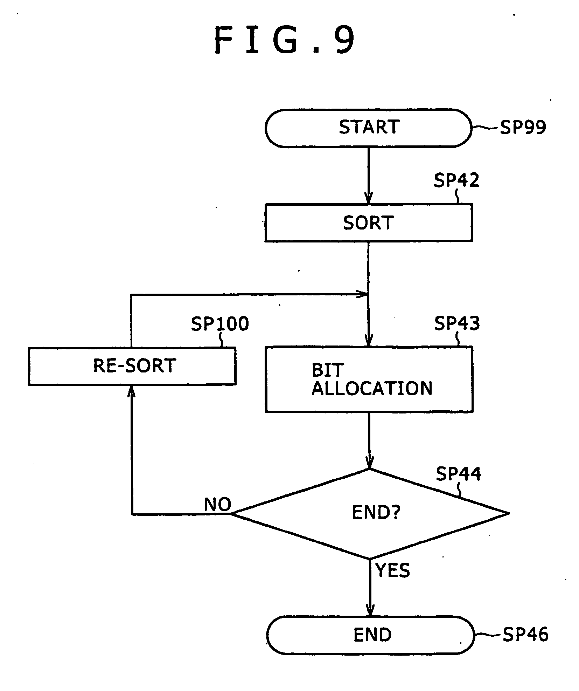

FIG. 9 is a flowchart representing a processing procedure of a dynamic bit allocation unit 4 in an encoder according to a second embodiment of the present invention, for comparison with FIG. 1. The encoder according to the second embodiment is formed in the same manner as the encoder described above with reference to FIG. 16 except for the different processing procedure of the dynamic bit allocation unit 4 in the encoder according to the second embodiment. Therefore the following description will be made using the configuration of FIG. 16 as appropriate. In addition, the dynamic bit allocation unit 4 is formed in the same manner as in the encoder described above with reference to FIG. 1 except for a different re-sort process in step SP100. Thus, in the following description, the same processes as those of the dynamic bit allocation unit 4 described in the first embodiment are identified by the same reference numerals, and repeated description thereof will be omitted.

As with the dynamic bit allocation unit 4 of the first embodiment, starting this processing procedure, the dynamic bit allocation unit 4 proceeds from step SP99 to step SP42, where the dynamic bit allocation unit 4 sorts the MNR of each subband signal together with an index index and the like, and stores the MNR of each subband signal in a memory together with the index index and the like. In next step SP43, the dynamic bit allocation unit 4 allocates bits to a subband signal with an MNR having a lowest value, and then recalculates the MNR of the subband signal to which the bits are allocated. In next step SP44, the dynamic bit allocation unit 4 determines whether all allocatable bits are allocated. When a negative result is obtained in step SP44, the dynamic bit allocation unit 4 proceeds from step SP44 to step SP100.

In this step SP100, the dynamic bit allocation unit 4 applies the MNR recalculated in step SP44 to re-sort the MNRs recorded in the memory.

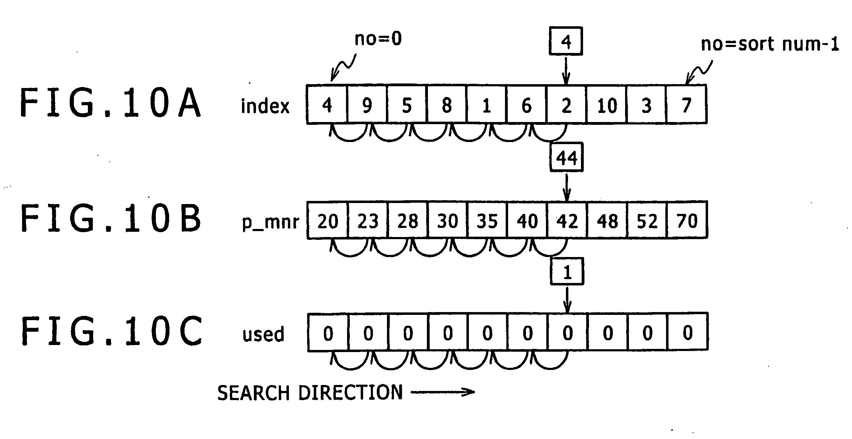

In the sort process in step SP100, the dynamic bit allocation unit 4 sorts the MNRs by partly changing the sequence of a sort result so far. At this time, as shown in FIGS. 10A, 10B, and 10C for comparison with FIGS. 3A, 3B, and 3C, the dynamic bit allocation unit 4 sequentially moves combinations of the sort result so far to a head side as indicated by arrows in the memory where the sort result is recorded until an MNR having a value higher than the recalculated MNR is detected. When an MNR having a value higher than the recalculated MNR is detected, the dynamic bit allocation unit 4 records a combination including the recalculated MNR in a free space obtained by moving the combinations. Thus, the example of FIGS. 10A, 10B, and 10C is a case where bits are allocated to the subband signal of index = 4 stored in the head area of the memory space, a value 44 is obtained by recalculating the MNR, records of combinations of no = 1 to 6 are moved to the head side, and the recalculation result is recorded in a free space of no = 6 obtained by moving the combinations.

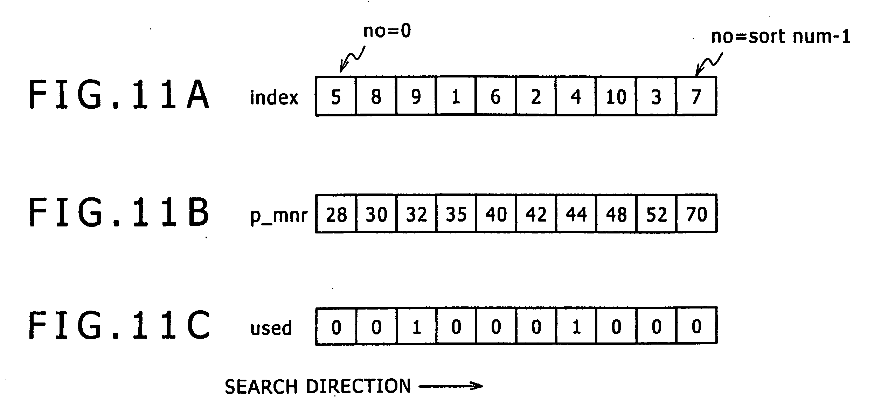

After completing the process of step SP100, the dynamic bit allocation unit 4 returns to step SP43, where the dynamic bit allocation unit 4 detects an MNR having a lowest value recorded at the head of processing objects from the sort result obtained by the sorting in step SP100. Thus, in the example of FIGS. 10A, 10B, and 10C, an MNR of index = 9 identified by no = 1 is detected as MNR having a lowest value. Therefore, in this case, the dynamic bit allocation unit 4 allocates bits to the subband signal of index = 9 and recalculates the MNR in step SP43, and then further sorts the MNRs in next step SP100 as shown in FIGS. 11A, 11B, and 11C. Incidentally, FIGS. 11A, 11B, and 11C illustrate a case where an MNR having a value 32 is obtained by recalculation for the subband signal of index = 9.

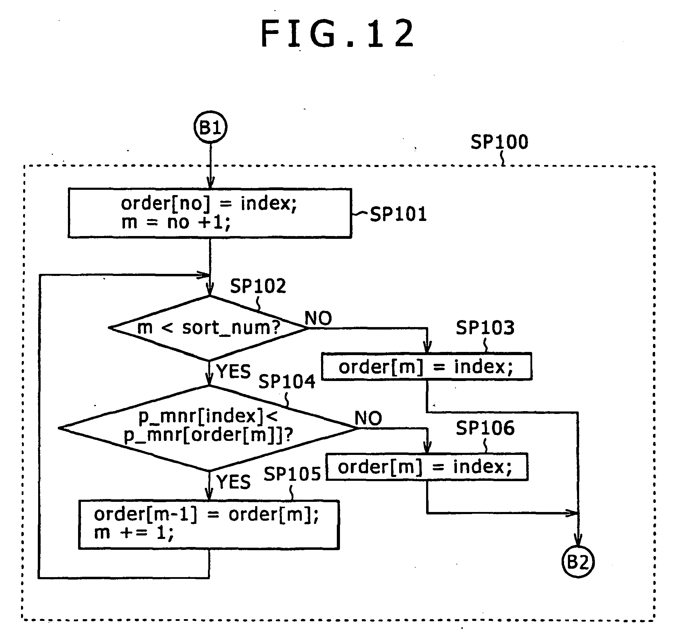

FIG. 12 is a flowchart representing in detail the process of step SP100 in FIG. 9. Starting this processing procedure, the dynamic bit allocation unit 4 proceeds to step SP101, where the dynamic bit allocation unit 4 sets the combination of a subband signal to which bits are allocated in previous step SP43 as a sort object (order[no] = index). In addition, the dynamic bit allocation unit 4 sets a variable m for identifying a comparison object to no + 1, and thereby sets an MNR combination recorded at a position immediately succeeding the sort object as the comparison object.

Next, the dynamic bit allocation unit 4 proceeds to step SP102, where the dynamic bit allocation unit 4 determines whether the variable m is lower than a variable sort num. No comparison object exists after the comparison object is sequentially changed from a head side to an end side and a last MNR combination becomes the comparison object. Hence, in this case, the dynamic bit allocation unit 4 obtains a negative result in step SP102, and then proceeds from step SP102 to step SP103.

In step SP103, the dynamic bit allocation unit 4 records the combination of the sort object at an end in a memory space (order[sort num - 1] = index). The dynamic bit allocation unit 4 returns to step SP43.

When a positive result is obtained in step SP102, on the other hand, the dynamic bit allocation unit 4 proceeds to step SP104. In step SP104, the dynamic bit allocation unit 4 determines whether the MNR (p mnr[index]) of the sort object identified by the index index is lower than the MNR (p mnr[order[m]]) of the combination identified by the variable m.

When a positive result is obtained in step SP104, the dynamic bit allocation unit 4 proceeds to step SP105, where the dynamic bit allocation unit 4 moves the record of the comparison object in the memory space to the head side by one (order[m - 1] = order[m]). In addition, the dynamic bit allocation unit 4 increments the variable m by a value of one to change the comparison object to a combination recorded at an immediately succeeding position. The dynamic bit allocation unit 4 then returns to step SP102.

When a negative result is obtained in step SP104, on the other hand, the dynamic bit allocation unit 4 proceeds from step SP104 to step SP106, where the dynamic bit allocation unit 4 records the combination of the sort object at a recording position immediately preceding the comparison object (order [m] = index). The dynamic bit allocation unit 4 then proceeds to step SP43.

The present embodiment can provide similar effects to those of the first embodiment even when the re-sorting process is performed from a side of lower MNR values.

### [Third Embodiment]

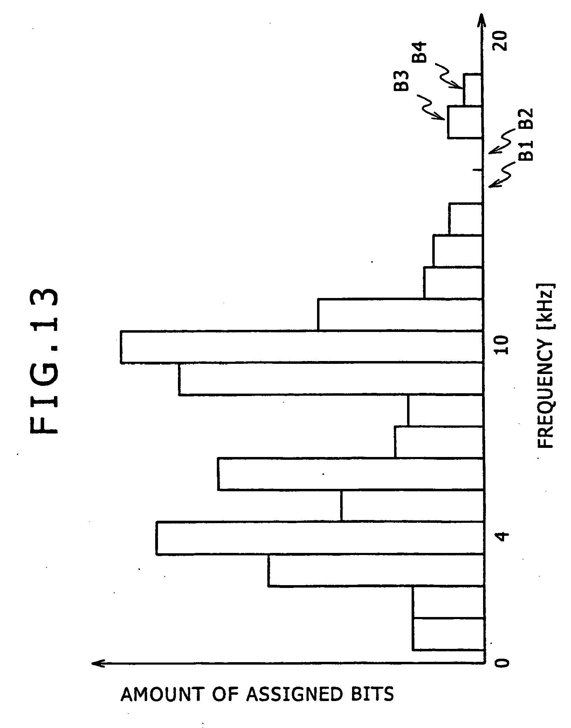

When bit allocation based on psychoacoustic analysis and encoding are performed, depending on frequency characteristics of the audio signal, there occurs a case where as shown in FIG. 13, no bits are allocated to particular subband signals B1 and B2 on a high-frequency side, and bits are allocated to subband signals B3 and B4 having higher frequencies than the subband signals B1 and B2. A situation as shown in FIG. 13 tends to occur especially when the encoding process is performed at a low bit rate. Results of various studies have shown that the sound quality of the decoded audio signal is degraded when, as described above, no bits are allocated to particular subband signals B1 and B2 on a high-frequency side, and bits are allocated to subband signals B3 and B4 having higher frequencies than the subband signals B1 and B2.

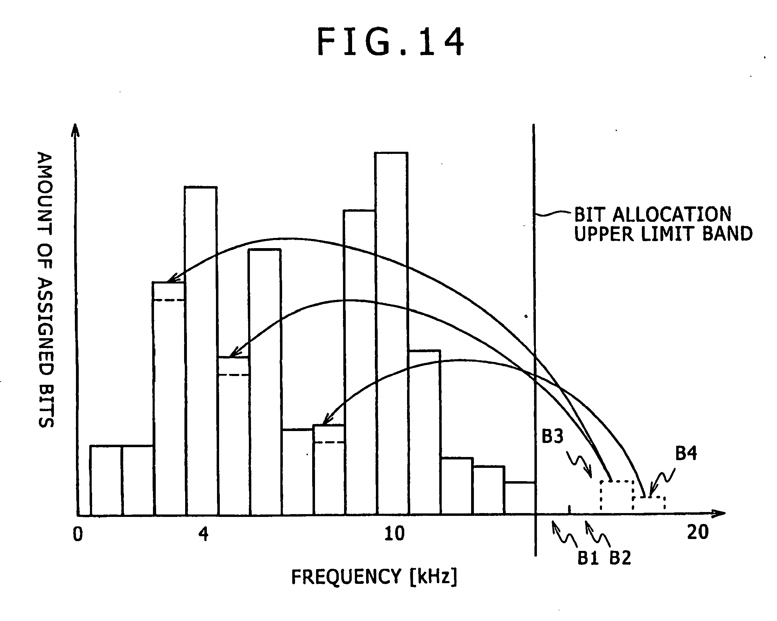

Thus, as shown in FIG. 14 for comparison with FIG. 13, the present embodiment detects the subband signals B3 and B4 that cause the degradation in sound quality, and reallocates the bits allocated to the subband signals B3 and B4 to other subband signals, as indicated by arrows.

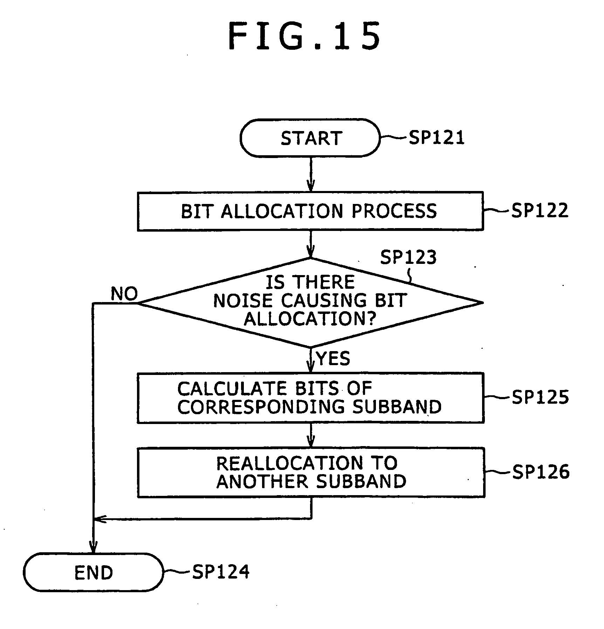

FIG. 15 is a flowchart of a processing procedure of a dynamic bit allocation unit 4 in an encoder according to a third embodiment of the present invention. The encoder according to the third embodiment is formed in the same manner as the encoder described above with reference to FIG. 16 except for the different processing procedure of the dynamic bit allocation unit 4 in the encoder according to the third embodiment. Therefore the following description will be made using the configuration of FIG. 16 as appropriate.

The dynamic bit allocation unit 4 performs the processing procedure for each block of an audio signal S1. Starting this processing procedure, the dynamic bit allocation unit 4 proceeds from step SP121 to step SP122, where the dynamic bit allocation unit 4 calculates a bit allocation to each subband signal by performing the processing procedure of FIG. 1 or FIG. 9.

Next, the dynamic bit allocation unit 4 proceeds to step SP123, where the dynamic bit allocation unit 4 determines whether there is a bit allocation to a subband signal causing degradation in sound quality. In step SP123, the dynamic bit allocation unit 4 determines that there is a bit allocation to a subband signal causing degradation in sound quality when there is no bit allocation to a subband signal in a band on a lower frequency side of a band of frequencies equal to and higher than a certain frequency, there is a bit allocation to a subband signal in a band on a higher frequency side, and further the number of bits allocated to the subband signal in the band on the higher frequency side is equal to or smaller than a certain number.

When a negative result is obtained in step SP123, the dynamic bit allocation unit 4 proceeds from step SP123 to step SP124, where the dynamic bit allocation unit 4 ends the processing procedure. When a positive result is obtained in step SP123, on the other hand, the dynamic bit allocation unit 4 proceeds from step SP123 to step SP125. In step SP125, the dynamic bit allocation unit 4 calculates the number of bits allocated to the subband signal causing the degradation in sound quality. Thus, in the example of FIG. 13, the dynamic bit allocation unit 4 calculates the number of bits allocated to the subband signals B3 and B4.

Next, the dynamic bit allocation unit 4 proceeds to step SP126, where the dynamic bit allocation unit 4 allocates the amount of bits which amount is calculated in step SP125 to another subband signal. The dynamic bit allocation unit 4 performs the process of step SP126 by performing the processing procedure of FIG. 1 or FIG. 9 again. Specifically, the dynamic bit allocation unit 4 first sets the statuses used of the subband signals B3 and B4 causing degradation in sound quality and the subband signals B1 and B2 that are adjacent on the lower frequency side to the subband signals B3 and B4 and to which no bits are allocated to indicating completion of bit allocation, so that no bits are to be allocated to the subband signals B1 to B4. In addition, the dynamic bit allocation unit 4 sets the amount of bits that have previously been allocated to the subband signals B3 and B4 as an amount of remaining allocatable bits, repeats the processes of re-sorting (step SP45 or step SP100) and bit allocation (step SP43) described above with reference to FIG. 1 or FIG. 9, and thereby allocates the bits that have previously been allocated to the subband signals B3 and B4 to other subband signals. Incidentally, the process of step SP126 may be performed by restarting the process of FIG. 1 or FIG. 9 from the beginning. In addition, a setting may be simply made so that no bits are allocated to only the subband signals B3 and B4 that cause degradation in sound quality and to which bits have previously been allocated.

The present embodiment detects a bit allocation to a subband signal causing degradation in sound quality, and reallocates bits allocated to the subband signal to another subband signal. It is thereby possible to prevent degradation in sound quality by a simple process.

### [Fourth Embodiment]

It is to be noted that while in the foregoing embodiments, MNRs are sorted in order of increasing MNR value, the present invention is not limited to this, and MNRs may conversely be sorted in order of decreasing MNR value. Incidentally, in this case, of course, the process of detecting an MNR having a lowest value is performed in a manner opposite to that of the foregoing embodiment, that is, from an end of a sort result, and the processes of MNR re-sorting and the like are performed in an opposite direction to that of the foregoing embodiment.

In addition, while in the foregoing embodiments, the encoder is formed by a digital signal processor, the present invention is not limited to this, and is applicable to cases where an audio signal is subjected to an editing process by a computer, for example, and is thus widely applicable to cases where an audio signal is subjected to an encoding process by executing a program of arithmetic processing means, for example. Incidentally, the program of an audio signal encoding method which program is executed by such arithmetic processing means may be provided in a state of being recorded on various recording media such as optical disks, magnetic disks and memory cards, or may be provided via a network such as the Internet.

Further, in the foregoing embodiments, description has been made of a case where the present invention is applied to a process of encoding an audio signal by MPEG1 or MPEG2, and MNR is used as an evaluation criterion for allocating bits. However, the present invention is not limited to this, and is widely applicable to cases where the encoding process is performed in various formats using various evaluation criteria.

The present invention is applicable to cases where audio signals are encoded by Layer 1 and Layer 2 of MPEG1 and MPEG2, for example.

It should be understood by those skilled in the art that various modifications, combinations, subcombinations and alterations may occur depending on design requirements and other factors insofar as they are within the scope of the appended claims.

## Claims

1. An audio signal encoding method for dividing an audio signal into a plurality of subband signals, allocating bits to said subband signals on a basis of psychoacoustic analysis, and encoding said audio signal, said audio signal encoding method comprising the steps of:
defining an evaluation criterion for allocating said bits to each said subband signal on the basis of said psychoacoustic analysis;
calculating evaluation criterion values by calculating an evaluation criterion value for each said subband signal;
sorting said evaluation criterion values; and
allocating said bits to said plurality of subband signals by repeating a bit allocating step, an evaluation criterion value recalculating step, and a re-sorting step;
wherein said bit allocating step is a step of selecting one subband signal from said plurality of subband signals and allocating bits to said subband signal on a basis of one of a sort result of said sorting step and a sort result of said re-sorting step,
wherein said evaluation criterion value recalculating step is a step of recalculating said evaluation criterion value of said subband signal to which the bits are allocated in said bit allocating step,
wherein said re-sorting step is a step of applying said evaluation criterion value calculated in said evaluation criterion recalculating step to the corresponding subband signal and sorting said evaluation criterion values, and
wherein said re-sorting step sorts said evaluation criterion values by partly changing a sequence of the sort result used for bit allocation in said bit allocating step that immediately precedes,
**characterized in that** partly changing the sequence of said sort result in said re-sorting step is a process of:
- sequentially setting said evaluation criterion values of the sort result used for the bit allocation in said bit allocating step that immediately precedes as comparison objects, and sequentially comparing the comparison objects with said evaluation criterion value calculated in said evaluation criterion recalculating step that immediately precedes, and
- on a basis of comparison results, sequentially changing positions of said comparison objects in said sort result, and inserting into said sort result said evaluation criterion value calculated in said evaluation criterion value recalculating step that immediately precedes.

2. The audio signal encoding method as claimed in claim 1,
wherein said evaluation criterion is a mask to noise ratio.

3. The audio signal encoding method as claimed in claim 1, further comprising the steps of:
detecting a subband signal on a high frequency side, said bits being allocated to said subband signal on the high frequency side in said bit allocating step, and said bits not being allocated to an adjacent subband signal on a low frequency side in said bit allocating step, on a basis of a process result of said repetitive process step; and
reallocating said bits allocated to said subband signal detected in said subband signal detecting process step to a subband signal having a lower frequency than said subband signal.

4. A program of an audio signal encoding method, said audio signal encoding method dividing an audio signal into a plurality of subband signals, allocating bits to said subband signals on a basis of psychoacoustic analysis, and encoding said audio signal, said program being executable by arithmetic processing means, said program comprising the steps of:
defining an evaluation criterion for allocating said bits to each said subband signal on the basis of said psychoacoustic analysis;
calculating evaluation criterion values by calculating an evaluation criterion value for each said subband signal;
sorting said evaluation criterion values; and
allocating said bits to said plurality of subband signals by repeating a bit allocating step, an evaluation criterion value recalculating step, and a re-sorting step;
wherein said bit allocating step is a step of selecting one subband signal from said plurality of subband signals and allocating bits to said subband signal on a basis of one of a sort result of said sorting step and a sort result of said re-sorting step,
wherein said evaluation criterion value recalculating step is a step of recalculating said evaluation criterion value of said subband signal to which the bits are allocated in said bit allocating step,
wherein said re-sorting step is a step of applying said evaluation criterion value calculated in said evaluation criterion value recalculating step to the corresponding subband signal and sorting said evaluation criterion values,
wherein said re-sorting step sorts said evaluation criterion values by partly changing a sequence of the sort result used for bit allocation in said bit allocating step that immediately precedes,
**characterized in that** partly changing the sequence of said sort result in said re-sorting step is a process of:
- sequentially setting said evaluation criterion values of the sort result used for the bit allocation in said bit allocating step that immediately precedes as comparison objects, and sequentially comparing the comparison objects with said evaluation criterion value calculated in said evaluation criterion value recalculating step that immediately precedes, and
- on a basis of comparison results, sequentially changing positions of said comparison objects in said sort result, and inserting into said sort result said evaluation criterion value calculated in said evaluation criterion value recalculating step that immediately precedes.

5. A recording medium on which a program of an audio signal encoding method is recorded, said audio signal encoding method dividing an audio signal into a plurality of subband signals, allocating bits to said subband signals on a basis of psychoacoustic analysis, and encoding said audio signal, said program being executable by arithmetic processing means, said program comprising the steps of:
defining an evaluation criterion for allocating said bits to each said subband signal on the basis of said psychoacoustic analysis;
calculating evaluation criterion values by calculating an evaluation criterion value for each said subband signal;
sorting said evaluation criterion values; and
allocating said bits to said plurality of subband signals by repeating a bit allocating step, an evaluation criterion value recalculating step, and a re-sorting step;
wherein said bit allocating step is a step of selecting one subband signal from said plurality of subband signals and allocating bits to said subband signal on a basis of one of a sort result of said sorting step and a sort result of said re-sorting step,
wherein said evaluation criterion value recalculating step is a step of recalculating said evaluation criterion value of said subband signal to which the bits are allocated in said bit allocating step,
wherein said re-sorting step is a step of applying said evaluation criterion value calculated in said evaluation criterion value recalculating step to the corresponding subband signal and sorting said evaluation criterion values,
wherein said re-sorting step sorts said evaluation criterion values by partly changing a sequence of the sort result used for bit allocation in said bit allocating step that immediately precedes,
**characterized in that** partly changing the sequence of said sort result in said re-sorting step is a process of:
- sequentially setting said evaluation criterion values of the sort result used for the bit allocation in said bit allocating step that immediately precedes as comparison objects, and sequentially comparing the comparison objects with said evaluation criterion value calculated in said evaluation criterion value recalculating step that immediately precedes, and
- on a basis of comparison results, sequentially changing positions of said comparison objects in said sort result, and inserting into said sort result said evaluation criterion value calculated in said evaluation criterion value recalculating step that immediately precedes.

6. An audio signal encoding device for dividing an audio signal into a plurality of subband signals, allocating bits to said subband signals on a basis of psychoacoustic analysis, and encoding said audio signal,
wherein an evaluation criterion for allocating said bits to each said subband signal is defined on the basis of said psychoacoustic analysis;
wherein evaluation criterion values are calculated by calculating an evaluation criterion value for each said subband signal
wherein said evaluation criterion values are subject to a sort;
wherein said bits are allocated to said plurality of subband signals by repeating bit allocation, evaluation criterion value recalculation, and a re-sort;
wherein in said bit allocation, one subband signal is selected from said plurality of subband signals and bits are allocated to said subband signal on a basis of one of a sort result of said sort and a sort result of said re-sort;
wherein in said evaluation criterion value recalculation, said evaluation criterion value of said subband signal to which the bits are allocated in said bit allocation is recalculated;
wherein in said re-sort, said evaluation criterion value calculated in said evaluation criterion value recalculation is applied to the corresponding subband signal and said evaluation criterion values are sorted;
wherein in said re-sort, said evaluation criterion values are sorted by partly changing a sequence of the sort result used for bit allocation in said bit allocation that immediately precedes,
**characterized in that** partly changing the sequence of said sort result in said re-sort is a process of:
- sequentially setting said evaluation criterion values of the sort result used for the bit allocation in said bit allocation that immediately precedes as comparison objects, and sequentially comparing the comparison objects with said evaluation criterion value calculated in said evaluation criterion value recalculation that immediately precedes, and
- on a basis of comparison results, sequentially changing positions of said comparison objects in said sort result, and inserting into said sort result said evaluation criterion value calculated in said evaluation criterion value recalculation that immediately precedes.

## Patentansprüche

1. Audiosignalcodierverfahren zum Unterteilen eines Audiosignals in eine Mehrzahl von Subbandsignalen, zum Allokieren von Bits zu den Subbandsignalen auf der Grundlage einer psychoakustischen Analyse und zum Codieren des Audiosignals,
wobei das Audiosignalcodierverfahren die Schritte aufweist:
Definieren eines Auswertekriteriums zum Allokieren der Bits zu jedem Subbandsignal auf der Grundlage der psychoakustischen Analyse,
Berechnen von Auswertekriteriumswerten durch Berechnen eines Auswertekriteriumswerts für jedes Subbandsignal,
Sortieren der Auswertekriteriumswerte und
Allokieren der Bits zur Mehrzahl von Subbandsignalen durch Wiederholen eines Bitallokierungsschritts, eines Auswertekriteriumswertneuberechungsschritts und eines Neusortierungsschritts,
wobei der Bitallokierungsschritt ein Schritt ist eines Auswählens eines Subbandsignals aus der Mehrzahl von Subbandsignalen und eines Allokierens von Bits zum Subbandsignal auf der Grundlage eines aus einem Sortierungsergebnis des Sortierungsschritts und aus einem Sortierungsergebnis des Neusortierungsschritts,
wobei der Auswertekriteriumswertneuberechnungsschritt ein Schritt ist eines Neuberechnens des Auswertekriteriumswerts des Subbandsignals, zu welchem im Bitallokierungsschritt die Bits allokiert werden,
wobei der Neusortierungsschritt ein Schritt ist eines Anwendens des Auswertekriteriumswerts, der im Auswertekriteriumswertneuberechnungsschritt berechnet wurde, auf das korrespondierende Subbandsignal und eines Sortierens der Auswertekriteriumswerte, und
wobei der Neusortierungsschritt die Auswertekriteriumswerte sortiert durch teilweises Ändern einer Sequenz des Sortierungsergebnisses, welches für die Bitallokierung im Bitallokierungsschritt, der unmittelbar vorangeht, verwendet wurde,
**dadurch gekennzeichnet, dass** ein teilweises Ändern der Sequenz des Sortierungsergebnisses im Neusortierungsschritt ein Vorgang ist:
- eines sequentiellen Einstellens des Auswertekriteriumswerts des Sortierungsergebnisses, welches im Bitallokierungsschritt, der unmittelbar vorangeht, zur Bitallokierung verwendet wurde, und zwar als Vergleichsobjekte, und eines sequentiellen Vergleichens der Vergleichsobjekte mit dem Auswertekriteriumswert, der im Auswertekriteriumswertneuberechnungsschritt, der unmittelbar vorangeht, berechnet wurde, und
- auf der Grundlage von Vergleichsergebnissen eines sequentiellen Änderns von Positionen der Vergleichsobjekte im Sortierungsergebnis und eines Einfügens des Auswertekriteriumswerts, der im Auswertekriteriumswertneuberechnungsschritt, der unmittelbar vorangeht, berechnet wurde, in das Sortierungsergebnis.

2. Audiosignalcodierverfahren nach Anspruch 1,
wobei das Auswertekriterium ein Maskierungs-zu-Rausch-Verhältnis ist.

3. Audiosignalcodierverfahren nach Anspruch 1,
welches des Weiteren die Schritte aufweist:
Detektieren eines Subbandsignals auf einer Hochfrequenzseite, wobei die Bits im Bitallokierungsschritt zum Subbandsignal auf der Hochfrequenzseite allokiert werden und wobei die Bits nicht zu einem benachbarten Subbandsignal auf einer Niedrigfrequenzseite im Bitallokierungsschritt allokiert werden, und zwar auf der Grundlage eines Prozessergebnisses des sich wiederholenden Prozessschritts, und
Reallokieren der zum Subbandsignal, welches im Subbandsignaldetektionsvorgangsschritt detektiert wurde, allokierten Bits zu einem Subbandsignal mit einer niedrigeren Frequenz als der des Subbandsignals.

4. Programm eines Audiosignalcodierverfahrens, wobei das Audiosignalcodierverfahren ein Audiosignal in eine Mehrzahl von Subbandsignalen unterteilt, Bits zu den Subbandsignalen auf der Grundlage einer psychoakustischen Analyse allokiert und das Audiosignal codiert, wobei das Programm ausführbar ist durch eine arithmetische Verarbeitungseinrichtung,
wobei das Programm die folgenden Schritte aufweist:
Definieren eines Auswertekriteriums zum Allokieren der Bits zu jedem Subbandsignal auf der Grundlage der psychoakustischen Analyse,
Berechnen von Auswertekriteriumswerten durch Berechnen eines Auswertekriteriumswerts für jedes Subbandsignal,
Sortieren der Auswertekriteriumswerte und
Allokieren der Bits zur Mehrzahl von Subbandsignalen durch Wiederholen eines Bitallokierungsschritts, eines Auswertekriteriumswertneuberechungsschritts und eines Neusortierungsschritts,
wobei der Bitallokierungsschritt ein Schritt ist eines Auswählens eines Subbandsignals aus der Mehrzahl von Subbandsignalen und eines Allokierens von Bits zum Subbandsignal auf der Grundlage eines aus einem Sortierungsergebnis des Sortierungsschritts und aus einem Sortierungsergebnis des Neusortierungsschritts,
wobei der Auswertekriteriumswertneuberechnungsschritt ein Schritt ist eines Neuberechnens des Auswertekriteriumswerts des Subbandsignals, zu welchem im Bitallokierungsschritt die Bits allokiert werden,
wobei der Neusortierungsschritt ein Schritt ist eines Anwendens des Auswertekriteriumswerts, der im Auswertekriteriumswertneuberechnungsschritt berechnet wurde, auf das korrespondierende Subbandsignal und eines Sortierens der Auswertekriteriumswerte, und
wobei der Neusortierungsschritt die Auswertekriteriumswerte sortiert durch teilweises Ändern einer Sequenz des Sortierungsergebnisses, welche für die Bitallokierung im Bitallokierungsschritt, der unmittelbar vorangeht, verwendet wurde,
**dadurch gekennzeichnet,**
**dass** ein teilweises Ändern der Sequenz des Sortierungsergebnisses im Neusortierungsschritt ein Vorgang ist:
- eines sequentiellen Einstellens des Auswertekriteriumswerts des Sortierungsergebnisses, welches im Bitallokierungsschritt, der unmittelbar vorangeht, zur Bitallokierung verwendet wurde, und zwar als Vergleichsobjekte, und eines sequentiellen Vergleichens der Vergleichsobjekte mit dem Auswertekriteriumswert, der im Auswertekriteriumswertneuberechnungsschritt, der unmittelbar vorangeht, berechnet wurde, und
- auf der Grundlage von Vergleichsergebnissen eines sequentiellen Änderns von Positionen der Vergleichsobjekte im Sortierungsergebnis und eines Einfügens des Auswertekriteriumswerts, der im Auswertekriteriumswertneuberechnungsschritt, der unmittelbar vorangeht, berechnet wurde, in das Sortierungsergebnis.

5. Aufzeichnungsmedium, auf welchem ein Programm eines Audiosignalcodierungsverfahrens aufgezeichnet ist, wobei das Audiosignalcodierverfahren ein Audiosignal in eine Mehrzahl von Subbandsignalen unterteilt, Bits zu den Subbandsignalen auf der Grundlage einer psychoakustischen Analyse allokiert und das Audiosignal codiert, wobei das Programm durch eine arithmetische Verarbeitungseinrichtung ausführbar ist, wobei das Programm die Schritte aufweist:
Definieren eines Auswertekriteriums zum Allokieren der Bits zu jedem Subbandsignal auf der Grundlage der psychoakustischen Analyse,
Berechnen von Auswertekriteriumswerten durch Berechnen eines Auswertekriteriumswerts für jedes Subbandsignal,
Sortieren der Auswertekriteriumswerte und
Allokieren der Bits zur Mehrzahl von Subbandsignalen durch Wiederholen eines Bitallokierungsschritts, eines Auswertekriteriumswertneuberechungsschritts und eines Neusortierungsschritts,
wobei der Bitallokierungsschritt ein Schritt ist eines Auswählens eines Subbandsignals aus der Mehrzahl von Subbandsignalen und eines Allokierens von Bits zum Subbandsignal auf der Grundlage eines aus einem Sortierungsergebnis des Sortierungsschritts und aus einem Sortierungsergebnis des Neusortierungsschritts,
wobei der Auswertekriteriumswertneuberechnungsschritt ein Schritt ist eines Neuberechnens des Auswertekriteriumswerts des Subbandsignals, zu welchem im Bitallokierungsschritt die Bits allokiert werden,
wobei der Neusortierungsschritt ein Schritt ist eines Anwendens des Auswertekriteriumswerts, der im Auswertekriteriumswertneuberechnungsschritt berechnet wurde, auf das korrespondierende Subbandsignal und eines Sortierens der Auswertekriteriumswerte, und
wobei der Neusortierungsschritt die Auswertekriteriumswerte sortiert durch teilweises Ändern einer Sequenz des Sortierungsergebnisses, welche für die Bitallokierung im Bitallokierungsschritt, der unmittelbar vorangeht, verwendet wurde,
**dadurch gekennzeichnet,**
**dass** ein teilweises Ändern der Sequenz des Sortierungsergebnisses im Neusortierungsschritt ein Vorgang ist:
- eines sequentiellen Einstellens des Auswertekriteriumswerts des Sortierungsergebnisses, welches im Bitallokierungsschritt, der unmittelbar vorangeht, zur Bitallokierung verwendet wurde, und zwar als Vergleichsobjekte, und eines sequentiellen Vergleichens der Vergleichsobjekte mit dem Auswertekriteriumswert, der im Auswertekriteriumswertneuberechnungsschritt, der unmittelbar vorangeht, berechnet wurde, und
- auf der Grundlage von Vergleichsergebnissen eines sequentiellen Änderns von Positionen der Vergleichsobjekte im Sortierungsergebnis und eines Einfügens des Auswertekriteriumswerts, der im Auswertekriteriumswertneuberechnungsschritt, der unmittelbar vorangeht, berechnet wurde, in das Sortierungsergebnis.

6. Audiosignalcodiereinrichtung zum Unterteilen eines Audiosignals in eine Mehrzahl von Subbandsignalen, zum Allokieren von Bits zu den Subbandsignalen auf der Grundlage einer psychoakustischen Analyse und zum Codieren des Audiosignal,
wobei ein Auswertekriterium zum Allokieren der Bits zu jedem Subbandsignal auf der Grundlage der psychoakustischen Analyse definiert wird,
wobei Auswertekriteriumswerte berechnet werden durch Berechnen eines Auswertekriteriumswerts für jedes Subbandsignal,
wobei die Auswertekriteriumswerte Gegenstand eines Sortierens sind,
wobei die Bits zu der Mehrzahl von Subbandsignalen allokiert werden durch Wiederholen einer Bitallokierung, einer Auswertekriteriumswertneuberechung und einer Neusortierung,
wobei bei der Bitallokierung ein Subbandsignal aus der Mehrzahl von Subbandsignalen ausgewählt wird und Bits zum Subbandsignal auf der Grundlage eines aus einem Sortierungsergebnis der Sortierung und aus einem Sortierungsergebnis der Neusortierung allokiert werden,
wobei bei der Auswertekriteriumswertneuberechnung der Auswertekriteriumswert des Subbandsignals, zu welchem die Bits im Bitallokierungsschritt allokiert werden, neuberechnet wird,
wobei bei der Neusortierung der Auswertekriteriumswert, der bei der Auswertekriteriumswertneuberechnung berechnet wurde, auf das korrespondierende Subbandsignal angewendet wird und die Auswertekriteriumswerte sortiert werden,
wobei bei der Neusortierung die Auswertekriteriumswerte sortiert werden durch teilweises Ändern einer Sequenz des Sortierungsergebnisses, welches bei der Bitallokierung, die unmittelbar vorangeht, für die Bitallokierung verwendet wurde,
**dadurch gekennzeichnet,**
**dass** ein teilweises Ändern der Sequenz des Sortierungsergebnisses bei der Neusortierung ein Vorgang ist:
- eines sequentiellen Einstellens der Auswertekriteriumswerte des Sortierungsergebnisses, welches für die Bitallokierung in der Bitallokierung, die unmittelbar vorangeht, verwendet wurde, als Vergleichsobjekte, und eines sequentiellen Vergleichens der Vergleichsobjekte mit dem Auswertekriteriumswert, der bei der Auswertekriteriumswertneuberechnung, die unmittelbar vorangeht, berechnet wurde, und
- auf der Grundlage von Vergleichsergebnissen eines sequentiellen Änderns von Positionen der Vergleichsobjekte im Sortierungsergebnis und eines Einfügens des Auswertekriteriumswerts, der in der Auswertekriteriumswertneuberechnung, die unmittelbar vorangeht, berechnet wurde, in das Sortierungsergebnis.

## Revendications

1. Procédé de codage d'un signal audio pour diviser un signal audio en une pluralité de signaux de sous-bandes, allouer des bits auxdits signaux de sous-bandes en fonction d'une analyse psycho-acoustique, et coder ledit signal audio, ledit procédé de codage de signal audio comportant les étapes consistant à :
définir un critère d'évaluation pour allouer lesdits bits à chaque signal de sous-bandes en fonction de ladite analyse psycho-acoustique ;
calculer des valeurs de critère d'évaluation en calculant une valeur de critère d'évaluation pour chaque signal de sous-bandes ;
trier lesdites valeurs de critère d'évaluation ; et
allouer lesdits bits à ladite pluralité de signaux de sous-bandes en répétant une étape d'allocation de bits, une étape de recalcul de valeur de critère d'évaluation, et une nouvelle étape de tri ;
dans lequel ladite étape d'allocation de bits est une étape pour sélectionner un signal de sous-bandes à partir de ladite pluralité de signaux de sous-bandes et allouer des bits audit signal de sous-bandes en fonction de l'un d'un résultat de tri de ladite étape de tri et d'un résultat de tri de ladite nouvelle étape de tri,
dans lequel ladite étape de recalcul de valeur de critère d'évaluation est une étape de pour recalculer ladite valeur de critère d'évaluation dudit signal de sous-bandes auquel les bits sont alloués pendant ladite étape d'allocation de bits,
dans lequel ladite nouvelle étape de tri est une étape pour appliquer ladite valeur de critère d'évaluation calculée lors de ladite étape de recalcul de valeur de critère d'évaluation au signal de sous-bandes correspondant et trier lesdites valeurs de critère d'évaluation, et
dans lequel ladite nouvelle étape de tri trie lesdites valeurs de critère d'évaluation en changeant partiellement une séquence du résultat de tri utilisé pour l'allocation de bits lors de ladite étape d'allocation de bits qui est immédiatement précédente,
**caractérisé en ce que** le changement partiel de la séquence dudit résultat de tri lors de ladite étape de retri est un processus de consistant à :
- déterminer séquentiellement lesdites valeurs de critère d'évaluation du résultat de tri utilisé pour l'allocation de bits lors de ladite étape d'allocation de bits qui est immédiatement précédente en tant qu'objets de comparaison, et comparer séquentiellement les objets de comparaison à ladite valeur de critère d'évaluation calculée lors de l'étape de recalcul de valeur de critère d'évaluation qui est immédiatement précédente, et
- en fonction des résultats de comparaison, changer séquentiellement les positions desdits objets de comparaison dans ledit résultat de tri, et insérer dans ledit résultat de tri ladite valeur de critère d'évaluation calculée lors de ladite étape de recalcul de valeur de critère d'évaluation qui est immédiatement précédente.

2. Procédé de codage de signal audio selon la revendication 1, dans lequel ledit critère d'évaluation est un masque pour un rapport de bruit.

3. Procédé de codage de signal audio selon la revendication 1, comportant en outre les étapes consistant à:
détecter un signal de sous-bandes sur un côté haute fréquence, lesdits bits étant alloués audit signal de sous-bandes sur le côté haute fréquence pendant ladite étape d'allocation de bits, et lesdits bits n'étant pas alloués à un signal de sous-bandes adjacent sur un côté basse fréquence lors de ladite étape d'allocation de bits, en fonction d'un résultat de processus de ladite étape de processus répétitif ; et
réallouer lesdits bits alloués audit signal de sous-bandes détecté lors de ladite étape de processus de détection de signal de sous-bandes à un signal de sous-bandes possédant une fréquence inférieure audit signal de sous-bandes.

4. Programme d'un procédé de codage de signal audio, ledit procédé de codage du signal audio divisant un signal audio en une pluralité de signaux de sous-bandes, allouant des bits auxdits signaux de sous-bandes en fonction d'une analyse psycho-acoustique, et coder ledit signal audio, ledit programme étant exécuté par un moyen de traitement arithmétique, ledit programme comportant les étapes consistant à :
définir un critère d'évaluation pour allouer lesdits bits à chaque signal de sous-bandes en fonction de ladite analyse psycho-acoustique ;
calculer des valeurs de critère d'évaluation en calculant une valeur de critère d'évaluation pour chaque signal de sous-bandes ;
trier lesdites valeurs de critère d'évaluation ; et
allouer lesdits bits à ladite pluralité de signaux de sous-bandes en répétant une étape d'allocation de bits, une étape de recalcul de valeur de critère d'évaluation, et une nouvelle étape de tri ;
dans lequel ladite étape d'allocation de bits est une étape pour sélectionner un signal de sous-bandes à partir de ladite pluralité de signaux de sous-bandes et allouer des bits audit signal de sous-bandes en fonction de l'un d'un résultat de tri de ladite étape de tri et d'un résultat de tri de ladite nouvelle étape de tri,
dans lequel ladite étape de recalcul de valeur de critère d'évaluation est une étape de recalcul de ladite valeur de critère d'évaluation dudit signal de sous-bandes auquel les bits sont alloués lors de ladite étape d'allocation de bits,
dans lequel ladite nouvelle étape de tri est une étape pour appliquer ladite valeur de critère d'évaluation calculée lors de ladite étape de recalcul de valeur de critère d'évaluation au signal de sous-bandes correspondant et trier lesdites valeurs de critère d'évaluation,
dans lequel ladite nouvelle étape de tri trie lesdites valeurs de critère d'évaluation en changeant partiellement une séquence du résultat de tri utilisé pour une allocation de bits lors de ladite étape d'allocation de bits qui est immédiatement précédente,
**caractérisé en ce que** le changement partiel de la séquence dudit résultat de tri pendant ladite étape de retri est un processus consistant à :
- déterminer séquentiellement lesdites valeurs de critère d'évaluation du résultat de tri utilisé pour l'allocation de bits pendant ladite étape d'allocation de bits qui est immédiatement précédente en tant qu'objets de comparaison, et comparer séquentiellement les objets de comparaison à ladite valeur de critère d'évaluation calculée pendant l'étape de recalcul de valeur de critère d'évaluation qui est immédiatement précédente, et
- en fonction des résultats de comparaison, changer séquentiellement les positions desdits objets de comparaison dans ledit résultat de tri, et insérer dans ledit résultat de tri ladite valeur de critère d'évaluation calculée pendant l'étape de recalcul de critère d'évaluation qui est immédiatement précédente.

5. Support d'enregistrement sur lequel est enregistré un programme d'un procédé de codage du signal audio, ledit procédé de codage du signal audio divisant un signal audio en une pluralité de signaux de sous-bandes, allouant des bits auxdits signaux de sous-bandes en fonction d'une analyse psycho-acoustique, et codant ledit signal audio, ledit programme pouvant être exécuté par un moyen de traitement arithmétique, ledit programme comportant les étapes consistant à :
définir un critère d'évaluation pour allouer lesdits bits à chaque signal de sous-bandes en fonction de ladite analyse psycho-acoustique ;
calculer des valeurs de critère d'évaluation en calculant une valeur de critère d'évaluation pour chaque signal de sous-bandes ;
trier lesdites valeurs de critère d'évaluation ; et
allouer lesdits bits à ladite pluralité de signaux de sous-bandes en répétant une étape d'allocation de bits, une étape de recalcul de valeur de critère d'évaluation, et une nouvelle étape de tri ;
dans lequel ladite étape d'allocation de bits est une étape pour sélectionner un signal de sous-bandes à partir de ladite pluralité de signaux de sous-bandes et allouer des bits audit signal de sous-bandes en fonction de l'un d'un résultat de tri de ladite étape de tri et d'un résultat de tri de ladite nouvelle étape de tri,
dans lequel ladite étape de recalcul de valeur de critère d'évaluation est une étape de recalcul de ladite valeur de critère d'évaluation dudit signal de sous-bandes auquel les bits sont alloués lors de ladite étape d'allocation de bits,
dans lequel ladite nouvelle étape de tri est une étape pour appliquer ladite valeur de critère d'évaluation calculée pendant l'étape de recalcul de valeur de critère d'évaluation au signal de sous-bandes correspondant et trier lesdites valeurs de critère d'évaluation,
dans lequel ladite nouvelle étape de tri trie lesdites valeurs de critère d'évaluation en changeant partiellement une séquence du résultat de tri utilisé pour une allocation de bits lors de ladite étape d'allocation de bits qui est immédiatement précédente,
**caractérisé en ce que** le changement partiel de la séquence dudit résultat de tri lors de ladite étape de retri est un processus consistant à :
déterminer séquentiellement lesdites valeurs de critère d'évaluation du résultat de tri utilisé pour l'allocation de bits pendant ladite étape d'allocation de bits qui est immédiatement précédente en tant qu'objets de comparaison, et comparer séquentiellement les objets de comparaison à ladite valeur de critère d'évaluation calculée pendant ladite étape de recalcul de critère d'évaluation qui est immédiatement précédente, et
en fonction des résultats de comparaison, changer séquentiellement les positions desdits objets de comparaison dans ledit résultat de tri, et insérer dans ledit résultat de tri ladite valeur de critère d'évaluation calculée pendant l'étape de recalcul de valeur de critère d'évaluation qui est immédiatement précédente.

6. Dispositif de codage du signal audio pour diviser un signal audio en une pluralité de signaux de sous-bandes, allouer des bits auxdits signaux de sous-bandes en fonction d'une analyse psycho-acoustique, et coder ledit signal audio,
dans lequel un critère d'évaluation pour allouer lesdits bits à chaque signal de sous-bandes est défini en fonction de ladite analyse psycho-acoustique ;
dans lequel des valeurs de critère d'évaluation sont calculées en calculant une valeur de critère d'évaluation pour chaque signal de sous-bandes ;
dans lequel lesdites valeurs de critère d'évaluation sont soumises à un tri ;
dans lequel lesdits bits sont alloués à ladite pluralité de signaux de sous-bandes en répétant une allocation de bits, un recalcul de valeur de critère d'évaluation, et un nouveau tri ;
dans lequel, lors de ladite allocation de bits, un signal de sous-bandes est sélectionné parmi ladite pluralité de signaux de sous-bandes et les bits sont alloués audit signal de sous-bandes en fonction de l'un d'un résultat de tri dudit tri et d'un résultat de tri dudit nouveau tri;
dans lequel, lors dudit recalcul de la valeur de critère d'évaluation, ladite valeur de critère d'évaluation dudit signal de sous-bandes auquel les bits sont alloués pendant ladite allocation de bits est recalculée ;
dans lequel, lors dudit nouveau tri, ladite valeur de critère d'évaluation calculée pendant ledit recalcul de la valeur de critère d'évaluation est appliquée au signal de sous-bandes correspondant et lesdites valeurs de critère d'évaluation sont triées ;
dans lequel, pendant ledit nouveau tri, lesdites valeurs de critère d'évaluation sont triées en changeant partiellement une séquence du résultat de tri utilisé pour l'allocation de bits pendant ladite allocation de bits qui est immédiatement précédente,
le changement partiel de la séquence dudit résultat de tri pendant ledit nouveau tri est un processus consistant à :
changer séquentiellement lesdites valeurs de critère d'évaluation du résultat de tri utilisé pour l'allocation de bits pendant ladite allocation de bits qui est immédiatement précédente en tant qu'objets de comparaison, et comparer séquentiellement les objets de comparaison à ladite valeur de critère d'évaluation calculée pendant ledit recalcul de la valeur de critère d'évaluation qui est immédiatement précédent, et
en fonction des résultats de comparaison, changer séquentiellement les positions desdits objets de comparaison dans ledit résultat de tri, et insérer dans ledit résultat de tri ladite valeur de critère d'évaluation calculée lors du recalcul de valeur de critère d'évaluation qui est immédiatement précédent.
